# EUROPÄISCHE PATENTSCHRIFT

(11) **EP 1 222 321 B1**
(45) Veröffentlichungstag und Bekanntmachung des Hinweises auf die Patenterteilung: **04.02.2004**
(21) Anmeldenummer: 00975832.7
(22) Anmeldetag: 05.10.2000
(51) Int. Cl.: C25D 5/18, C25D 17/00

(54) **VERFAHREN UND VORRICHTUNG ZUM ELEKTROLYTISCHEN BEHANDELN VON ELEKTRISCH LEITFÄHIGEN OBERFLÄCHEN VON GEGENEINANDER VEREINZELTEN PLATTEN- UND FOLIENMATERIALSTÜCKEN SOWIE ANWENDUNGEN DES VERFAHRENS**
METHOD AND DEVICE FOR THE ELECTROLYTIC TREATMENT OF ELECTRICALLY CONDUCTING SURFACES SEPARATED PLATES AND FILM MATERIAL PIECES IN ADDITION TO USES OF SAID METHOD
PROCEDE ET DISPOSITIF DE TRAITEMENT ELECTROLYTIQUE DE SURFACES ELECTROCONDUCTRICES DE PIECES EN CARTES OU EN FILMS SEPAREES ET APPLICATIONS DE CE PROCEDE

(30) Priorität: 20.10.1999 DE 19951324
(43) Veröffentlichungstag der Anmeldung: 17.07.2002
(73) Patentinhaber: ATOTECH Deutschland GmbH, 10553 Berlin (DE)
(72) Erfinder: HÜBEL, Egon, 90537 Feucht (DE)
(74) Vertreter: Effert, Bressel und Kollegen
(86) Internationale Anmeldenummer: PCT/DE2000/003569
(87) Internationale Veröffentlichungsnummer: WO 2001/029290

(56) Entgegenhaltungen:
- US-A- 4 169 770
- US-A- 4 534 832
- US-A- 5 401 370
- US-A- 5 788 824

## Beschreibung

Die Erfindung betrifft ein Verfahren und eine Vorrichtung zum elektrolytischen Behandeln von elektrisch leitfähigen Oberflächen von gegeneinander vereinzelten Platten- und Folienmaterialstücken und Anwendungen des Verfahrens, insbesondere zur Herstellung von Leiterplatten und Leiterfolien.

Zur Herstellung von Leiterplatten und Leiterfolien werden galvanotechnische Prozesse eingesetzt, um entweder Metall abzuscheiden oder andere elektrolytische Behandlungen durchzuführen, beispielsweise Metallätzverfahren. Seit etlichen Jahren werden zu diesem Zweck sogenannte Durchlaufanlagen eingesetzt, in denen das Material in horizontaler Richtung transportiert und während des Transportes mit Behandlungsflüssigkeit in Kontakt gebracht wird.

Eine derartige Durchlaufanlage ist beispielsweise in DE 36 234 481 A1 beschrieben. Diese Anlage weist Anoden, Stromzuführungen zu den zu beschichtenden Leiterplatten sowie Transportmittel auf. Die Transportmittel sind als eine endlos umlaufende, angetriebene Reihe einzelner Klammem ausgebildet, welche die Seitenränder der Leiterplatten fest halten und in der Transportrichtung bewegen. Über diese Klammern wird Strom auf die Leiterplatten geleitet. Hierzu werden die Klammern über Bürstenanordnungen mit Strom versorgt.

Eine andere Art der elektrischen Kontaktierung und des Transportes der Leiterplatten in einer Durchlaufanlage ist in DE 32 36 545 C3 beschrieben. Anstelle von Klammern werden in diesem Falle Kontakträder eingesetzt, die auf den bewegten Leiterplatten abrollen und auf diese Weise elektrischen Kontakt zu den Leiterplatten herstellen.

Beide Anlagen müssen aufwendig konstruiert werden, um die zum Teil großen Metallisierungsströme auf die Leiterplatten übertragen zu können. Für sehr hohe Metallisierungsströme bestehen noch keine befriedigenden Lösungen, da an den Kontakten (Klammern, Kontakträdern) grundsätzlich Kontaktwiderstände auftreten, so daß sich die Kontaktstellen durch den Stromfluß mitunter sehr stark erwärmen können und die kontaktierte Metallfläche beschädigt werden kann. Dieser Nachteil zeigt sich insbesondere bei solchen zu behandelnden Materialien, die, wie bei Leiterplatten und Leiterfolien, auf einer isolierenden Kemschicht eine sehr dünne Leiterschicht, meist aus Kupfer, aufweisen. Diese dünne Schicht kann bei Anwendung ausreichend großer Ströme leicht "durchbrennen". Die Vorrichtung der DE 36 32 545 C3 weist noch den weiteren Nachteil auf, daß sich Metall auch auf den Kontakträdern abscheidet und die Metallschicht insbesondere auf den Laufflächen Probleme bereiten kann. Nur durch einen Ausbau der Räder und eine nachfolgende Entfernung der abgeschiedenen Metallschicht kann dieses Problem behoben werden.

Ein grundsätzlicher Nachteil dieser Vorrichtung besteht darin, daß lediglich ganzflächig leitfähige Oberflächen elektrolytisch behandelt werden können, nicht jedoch elektrisch gegeneinander isolierte Strukturen.

Als Lösung zu letzterem Problem ist in WO 97/37062 A1 ein Verfahren zum elektrochemischen Behandeln von elektrisch gegeneinander isolierten Bereichen auf Leiterplatten vorgeschlagen worden. Danach werden die mit der Behandlungslösung in Kontakt gebrachten Leiterplatten mit stationären, von einer Stromquelle gespeisten Bürstenelektroden nacheinander in Kontakt gebracht, so daß ein elektrisches Potential an den einzelnen elektrisch leitfähigen Strukturen anliegen kann. Zwischen die vorzugsweise aus Metalldrähten gebildeten Bürsten und zwischen den Bürsten angeordnete Anoden wird ein elektrisches Potential angelegt.

Diese Vorrichtung weist den Nachteil auf, daß die Bürsten innerhalb sehr kurzer Zeit vollständig mit Metall überzogen werden, da etwa 90 % des Metalls auf den Bürsten abgeschieden wird und nur 10 % auf die zu metallisierenden Bereiche. Daher müssen die Bürsten bereits nach kurzer Betriebszeit wieder vom Metall befreit werden. Hierzu müssen die Bürsten wieder aus der Vorrichtung ausgebaut und vom Metall befreit werden, oder es sind aufwendig konstruierte Einrichtungen vorzusehen, mit deren Hilfe das Metall auf den Bürsten durch elektrochemische Umpolung der zu regenerierenden Bürsten wieder entfernt wird. Außerdem können die Bürstenspitzen feine Strukturen auf den Leiterplatten leicht schädigen. Dabei verschleißt das Bürstenmaterial ebenfalls schnell, indem feinste Teilchen abgerieben werden, die in das Bad gelangen und dort zu Störungen bei der Metallisierung führen. Insbesondere zur Metallisierung von sehr kleinen Strukturen, beispielsweise solche mit einer Breite bzw. Länge von 0,1 mm, müssen Bürsten mit sehr dünnen Drähten eingesetzt werden. Diese verschleißen besonders schnell. Von den verschlissenen Bürsten stammende Partikel gelangen dann in das Bad und in die Löcher der Leiterplatten und verursachen erhebliche Störungen.

Bei anderen bekannten Verfahren zur Metallisierung von elektrisch isolierten Strukturen auf Leiterplattenmaterial werden stromlose Metallisierungsprozesse genutzt. Allerdings sind diese Verfahren langsam, aufwendig in der Verfahrensführung und teuer, da größere Mengen an chemischen Stoffen verbraucht werden. Die verbrauchten Stoffe sind häufig umweltschädlich. Daher verursachen sie bei der Beseitigung weitere erhebliche Kosten. Außerdem ist nicht gewährleistet, daß nur die elektrisch leitfähigen Strukturen metallisiert werden. Es wird oft beobachtet, daß sich in diesem Falle das Metall auch auf den dazwischen liegenden elektrisch isolierenden Oberflächen abscheidet und zu Ausschuß führt.

Zum elektrolytischen Ätzen, Beizen und Metallisieren von Metallbändern und Metalldrähten sind Verfahren bekannt, die ohne elektrische Kontaktierung der Bänder und Drähte auskommen:

In EP 0 093 681 B1 ist ein Verfahren zum kontinuierlichen Beschichten von Drähten, Rohren und anderem Halbzeug aus Aluminium mit Nickel beschrieben. Bei diesem Verfahren wird das Halbzeug zuerst in einen ersten Badbehälter und danach in einen zweiten Badbehälter überführt. In dem ersten Badbehälter wird das Halbzeug an einer negativ gepolten Elektrode und im zweiten Badbehälter an einer positiv gepolten Elektrode vorbeigeführt. In den Badbehältern befindet sich ein Metallisierungsbad. Dadurch daß das Halbzeug elektrisch leitfähig ist und gleichzeitig mit beiden Metallisierungsbädern in Kontakt steht, ist der Stromkreis zwischen den Elektroden, die mit einer Stromquelle verbunden sind, geschlossen. Gegenüber der negativ gepolten Elektrode im ersten Badbehälter wird das Halbzeug anodisch gepolt. Gegenüber der positiv gepolten Elektrode im zweiten Badbehälter wird das Halbzeug dagegen kathodisch gepolt, so daß dort Metall abgeschieden werden kann.

In EP 0 838 542 A1 ist ein Verfahren zum elektrolytischen Beizen von metallischen Bändern, insbesondere Edelstahlbändern, Bändern aus Titan, Aluminium oder Nickel beschrieben, wobei der elektrische Strom ohne elektrisch leitende Berührung zwischen Band und Elektroden durch das Bad geleitet wird. Die Elektroden sind dem Band gegenüber angeordnet und kathodisch bzw. anodisch gepolt.

Aus EP 0 395 542 A1 ist ein Verfahren zum kontinuierlichen Beschichten eines aus Graphit, Aluminium oder dessen Legierungen bestehenden Substrats mit einem Metall bekannt, bei dem das Substrat nacheinander durch zwei miteinander verbundene, ein Aktivierungsbad bzw. ein Metallisierungsbad enthaltende Behälter geführt wird, wobei im ersten Behälter eine Kathode und im zweiten Behälter eine Anode angeordnet ist. Als Substrate können mit diesem Verfahren Stangen, Rohre, Drähte, Bänder und anderes Halbzeug beschichtet werden.

Schließlich ist in Patent Abstracts of Japan, C-315, Nov. 20, 1985, Vol. 9, No. 293, JP 60-135600 A eine Vorrichtung zur elektrolytischen Behandlung eines Stahlbandes offenbart. Das Band wird hierzu zwischen entgegengesetzt gepolten Elektroden durch ein Elektrolysebad hindurchgeführt. Um einen elektrischen Stromfluß zwischen den einander gegenüberliegenden, entgegengesetzt gepolten Elektroden zu verhindern, sind in der Ebene, in der das Bad geführt wird, Abschirmbleche zwischen den Elektroden vorgesehen.

Der vorliegenden Erfindung liegt von daher das Problem zugrunde, die Nachteile der bekannten elektrolytischen Behandlungsverfahren zu vermeiden und insbesondere eine Vorrichtung und ein Verfahren zu finden, mit denen mit geringem Aufwand eine kontinuierliche elektrolytische Behandlung von elektrisch leitfähigen Oberflächen von gegeneinander vereinzelten Platten- und Folienmaterialstücken möglich ist, insbesondere zur Herstellung von Leiterplatten und Leiterfolien, wobei auch gewährleistet sein soll, daß der apparative Aufwand gering und das Verfahren mit ausreichender Effizienz durchführbar ist. Insbesondere sollen das Verfahren und die Vorrichtung auch dazu geeignet sein, elektrisch isolierte metallische Strukturen elektrolytisch zu behandeln.

Gelöst wird dieses Problem durch das Verfahren nach Anspruch 1, die Anwendungen des Verfahrens nach den Ansprüchen 15, 16 und 18 und die Vorrichtung nach Anspruch 19. Bevorzugte Ausführungsformen der Erfindung sind in den Unteransprüchen angegeben.

Das erfindungsgemäße Verfahren und die Vorrichtung dienen zum elektrolytischen Behandeln von elektrisch leitfähigen Oberflächen von gegeneinander vereinzelten Platten- und Folienmaterialstücken, insbesondere zur Herstellung von Leiterplatten und Leiterfolien, wobei die elektrisch leitenden Oberflächen nicht direkt elektrisch kontaktiert werden. Dadurch ist es möglich, sowohl großflächige Bereiche auf den Materialstücken zu behandeln als auch strukturierte Bereiche, die elektrisch gegeneinander isoliert sind. Es können sowohl außenliegende Bereiche behandelt werden als auch Bohrlochwandungen in Leiterplatten.

Zur Durchführung des erfindungsgemäßen Verfahrens werden die Materialstücke durch eine Behandlungsanlage transportiert und dabei mit Behandlungsflüssigkeit in Kontakt gebracht. Eine Möglichkeit besteht darin, die Materialstücke in horizontaler Transportrichtung zu transportieren. Die Transportebene kann in diesem Fall sowohl senkrecht stehen als auch horizontal ausgerichtet sein. Eine derartige Anordnung wird in sogenannten Durchlaufanlagen verwirklicht, die beispielsweise zur Leiterplatten- und Leiterfolienherstellung üblicherweise verwendet werden. Hierzu werden die Materialstücke mit bekannten Mitteln der Leiterplattentechnik transportiert, beispielsweise mit Rollen oder Walzen.

Die erfindungsgemäße Vorrichtung weist folgende Merkmale auf:
a. mindestens eine Einrichtung zum In-Kontakt-Bringen der Materialstücke mit einer Behandlungsflüssigkeit, beispielsweise einen Behandlungsbehälter, in den die Materialstücke eingefahren werden können, oder geeignete Düsen, mit denen die Flüssigkeit an die Materialoberfläche gefördert werden kann;
b. geeignete Transportorgane für den Transport der vereinzelten Materialstücke durch eine Behandlungsanlage, vorzugsweise in horizontaler Transportrichtung in einer Transportebene, beispielsweise Rollen, Walzen oder andere Halteelemente, wie Klammern;
c. mindestens eine Elektrodenanordnung, jeweils bestehend aus mindestens einer kathodisch gepolten Elektrode und mindestens einer anodisch gepolten Elektrode, wobei die mindestens eine kathodisch gepolte Elektrode und die mindestens eine anodisch gepolte Elektrode mit der Behandlungsflüssigkeit in Kontakt bringbar sind; die Elektroden können zur einseitigen Behandlung der Materialstücke entweder nur an einer Seite der Transportbahn oder zur beidseitigen Behandlung auch an beiden Seiten angeordnet sein; die Elektroden einer Elektrodenanordnung sind auf eine Seite der Transportebene ausgerichtet;
d. mindestens eine Isolierwand zwischen den entgegengesetzt polarisierten Elektroden in den Elektrodenanordnungen; und
e. mindestens eine Strom/Spannungsquelle, die mit den Elektrodenanordnungen elektrisch verbunden ist, zur Erzeugung eines Stromflusses durch die Elektroden der Elektrodenanordnungen, wobei als Strom/Spannungsquelle ein Galvanogleichrichter oder eine vergleichbare Strom/Spannungsquelle oder eine Strom/Spannungsquelle zur Erzeugung von uni- oder bipolaren Strompulsen verwendet werden kann.

Zur Durchführung des erfindungsgemäßen Verfahrens werden die Materialstücke während des Transportes durch die Behandlungsanlage mit der Behandlungsflüssigkeit in Kontakt gebracht und an mindestens einer Elektrodenanordnung, jeweils bestehend aus mindestens einer kathodisch gepolten Elektrode und mindestens einer anodisch gepolten Elektrode, vorbeigeführt. Die kathodisch und anodisch gepolten Elektroden werden ebenfalls mit der Behandlungsflüssigkeit in Kontakt gebracht und mit einer Strom/Spannungsquelle verbunden, so daß zum einen ein Strom zwischen der kathodisch gepolten Elektrode und einem elektrisch leitfähigen Bereich auf den Materialstücken und zum anderen ein Strom zwischen der anodisch gepolten Elektrode und demselben elektrisch leitfähigen Bereich auf den Materialstücken fließt, wenn dieser Bereich beiden Elektroden gleichzeitig gegenüberliegt. Die Elektroden einer Elektrodenanordnung werden derart angeordnet, daß sie auf eine Seite der Materiaistücke ausgerichtet sind. Zwischen den Elektroden wird mindestens eine Isolierwand angeordnet.

Wird eine zweiseitige Behandlung der Materiaistücke gewünscht, müssen Elektroden an beiden Seiten des Materials angeordnet sein. Bei einseitiger Behandlung reichen Elektroden an einer Seite des Materials aus.

Die Elektroden werden beispielsweise mit einem Gatvanogfeichrichter elektrisch verbunden. Werden mehrere Elektrodenanordnungen eingesetzt, so können alle Elektrodenanordnungen mit demselben Galvanogleichrichter verbunden werden. Unter bestimmten Bedingungen kann es aber auch vorteilhaft sein, die einzelnen Elektrodenanordnungen mit jeweils einem Galvanogleichrichter zu verbinden. Die Galvanogleichrichter können als Strom- oder als Spannungsquelle betrieben werden. Bei der Behandlung von elektrisch zueinander isolierten Strukturen wird der Galvanogleichrichter vorzugsweise spannungsgeregelt und bei der Behandlung von vollflächigen Schichten vorzugsweise stromgeregelt.

Dadurch daß eine elektrisch leitfähige Verbindung durch eine zu behandelnde Leitschicht auf den Oberflächenbereichen der Materialstücke besteht, die der kathodisch gepolten Elektrode bzw. der anodisch gepolten Elektrode gleichzeitig gegenüberliegen, werden diese Oberflächenbereiche gegenüber den Elektroden jeweils anodisch bzw. kathodisch gepolt. Dadurch werden an diesen Stellen elektrochemische Prozesse in Gang gesetzt. Zur Erzeugung eines Stromflusses in den Materialstücken ist eine elektrische Kontaktierung der Materiatstücke nicht erforderlich. Die Materialstücke wirken als Zwischenleiter. Eine Elektrode und der dieser Elektrode gegenüberliegende Oberflächenbereich auf einem Materialstück kann als elektrolytische Teilzelle betrachtet werden. Eine der beiden Elektroden dieser Teilzelle wird durch das Materialstück selbst gebildet und die andere durch die Elektrode der Elektrodenanordnung. Dadurch daß das Materialstück einer kathodisch und einer anodisch gepolten Elektrode gegenüber angeordnet wird, ergibt sich eine Serienschaltung von zwei derartigen elektrolytischen Teilzellen, die von einer Strom/Spannungsquelle, beispielsweise einem Galvanogleichrichter, gespeist werden.

Der Vorteil des erfindungsgemäßen Verfahrens und der Vorrichtung gegenüber bekannten in der Leiterplattentechnik eingesetzten Verfahren und Vorrichtungen besteht darin, daß der apparative Aufwand zur Erzeugung eines Stromflusses in den zu behandelnden Materialstücken sehr viel geringer ist als bei den bekannten Verfahren und Vorrichtungen. Im vorliegenden Fall brauchen keine Kontaktierelemente vorgesehen zu werden. Die Materialstücke werden berührungslos gepolt. Dadurch ist die Abscheidung von Metall insbesondere mit einer geringen Schichtdicke sehr kostengünstig durchführbar. Ferner kann die Anordnung sehr einfach ausgeführt werden.

Das erfindungsgemäße Verfahren und die Vorrichtung ermöglichen insbesondere, elektrisch gegeneinander isolierte Metallinseln (Strukturen) mit geringem Aufwand elektrolytisch zu behandeln.

Gegenüber dem für die Leiterplattentechnik vorgeschlagenen Verfahren zur Metallisierung von isoliert zueinander angeordneten Metallinseln mit Bürstenanordnungen weisen das erfindungsgemäße Verfahren und die Vorrichtung den Vorteil auf, daß nur geringe Mengen an Metall auf der kathodisch gepolten Elektrode nutzlos abgeschieden werden. Der Rhythmus, mit dem das Metall von den kathodisch gepolten Elektroden wieder entfernt werden muß, liegt im Bereich von einigen Tagen bis Wochen. Außerdem stellt sich nicht das dortige Problem, daß die Bürstenelektroden bei der Berührung der zu metallisierenden Oberflächen verschleißen und dadurch Abriebpartikel das Behandlungsbad verunreinigen.

Da die gegensinnig zueinander gepolten Elektroden einer Elektrodenanordnung derart gegeneinander abgeschirmt werden, daß im wesentlichen kein elektrischer Strom direkt zwischen diesen Elektroden fließen kann, wird die Effizienz des Verfahrens gegenüber bekannten Verfahren und Vorrichtungen um ein Vielfaches gesteigert, da die Stromausbeute sehr viel größer ist. Erst indem erfindungsgemäß eine Isolierwand zwischen den entgegengesetzt gepolten Elektroden in den Elektrodenanordnungen vorgesehen ist, kann auch auf den elektrisch isolierten Strukturen eine Nettowirkung dadurch erzielt werden, daß der Abstand zwischen den Elektroden je nach der Größe der zu behandelnden Strukturen eingestellt wird, wobei ein ausreichender Wirkungsgrad des Verfahrens aufrechterhalten wird: Bei kleinen Strukturen ist ein kleiner Abstand erforderlich; bei größeren kann der Abstand auch größer sein. Durch die Isolierwand wird dabei ein direkter Stromfluß zwischen den entgegengesetzt gepolten Elektroden (Kurzschlußstrom) und ebenso ein direkter Stromfluß von der einen Elektrode zu dem Bereich auf dem zu behandelnden Substrat, das der anderen Elektrode gegenüber liegt, verhindert und umgekehrt.

Vorteilhaft ist auch die Option, daß sehr hohe Ströme problemlos auf die zu behandelnden Materialstücke übertragen werden können, ohne daß die elektrisch leitfähigen Oberflächenschichten der Materialstücke erhitzt und beschädigt oder gar zerstört werden, da keine Kontaktmittel erforderlich sind. Leiterplatten- und -folienmaterial weist meist außenliegende Metallkaschierungen auf, die eine Dicke von beispielsweise etwa 18 µm haben, Seit kurzem werden zur Herstellung sehr komplexer elektrischer Schaltungen auch Materialien eingesetzt, die sehr viel dünnere Außenschichten aus Metall aufweisen, beispielsweise etwa 0,5 µm dicke Schichten. Während diese Schichten mit der herkömmlichen Kontaktierungstechnik leicht "durchbrennen", ist diese Gefahr mit dem erfindungsgemäßen Verfahren nicht gegeben, da sich eine gleichmäßigere Stromverteilung innerhalb der Schicht ausbilden kann. Durch die wirkungsvolle Kühlung der zu beschichtenden Materialstücke durch die umgebende Behandlungsflüssigkeit kann die spezifische Strombelastung in der zu behandelnden Metallschicht sehr hoch eingestellt werden, beispielsweise auf bis zu 100 A/mm².

Das Verfahren und die Vorrichtung können zur Durchführung von beliebigen elektrolytischen Prozessen eingesetzt werden: Galvanisieren, Ätzen, Oxidieren, Reduzieren, Reinigen, elektrolytische Unterstützung an sich nicht elektrolytischer Prozesse, beispielsweise zum Starten eines stromlosen Metallisierungsprozesses. Beispielsweise können an den Oberflächen der Materialstücke auch Gase erzeugt werden, nämlich Wasserstoff in einer kathodischen Reaktion und/oder Sauerstoff in einer anodischen Reaktion. Es ist auch möglich, daß diese Einzelprozesse zusammen mit anderen Verfahren, beispielsweise Metallisierungsprozessen oder anderen elektrochemischen Prozessen, gleichzeitig ablaufen.

Anwendungsgebiete des erfindungsgemäßen Verfahrens bzw. der Vorrichtung sind unter anderem:
- das Abscheiden dünner Metallschichten;
- das selektive Galvanisieren von Strukturen (Inselgalvanisieren);
- das Übertragen von Oberflächenschichten aus Metall innerhalb einer Platte oder Folie von einem Opferbereich zu einem anderen Bereich, beispielsweise um Oberflächenschichten mit dem Metall zu verstärken, das von dem Opferbereich gewonnen wird;
- das Abdünnen von Strukturen durch Ätzen;
- das Entfernen und Abdünnen von vollflächigen Schichten durch Ätzen, beispielsweise der Abtrag einer Schicht von mehreren µm von den Oberflächen von Leiterplattenmaterial vor der Durchführung der Durchkontaktierung (gleichzeitiges elektrolytisches Entgraten der Bohrlöcher);
- das selektive Ätzen von Strukturen (Inselätzen);
- das großflächige oder selektive Pulsätzen;
- das Abscheiden von Metall mit Pulsstrom auf großen Flächen oder auf kleinen Strukturen;
- das elektrolytische Oxidieren und Reduzieren von metallischen Oberflächen;
- das elektrolytische Reinigen durch anodische oder kathodische Reaktion (beispielsweise unter elektrolytischer Bildung von Wasserstoff oder Sauerstoff);
- das Ätzreinigen mit elektrolytischer Unterstützung;
sowie weiterer Prozesse, bei denen eine elektrolytische Unterstützung vorteilhaft ist.

Besonders gut einsetzbar sind das Verfahren und die Vorrichtung zur Abscheidung dünner Metallschichten, beispielsweise von bis zu 5 µm dicken Schichten. Die Abscheidung derartiger Schichten ist beim Einsatz herkömmlicher Durchlaufanlagen zu teuer, da diese Anlagen wegen der erforderlichen Kontaktierung sehr aufwendig sind.

Zur Durchführung des erfindungsgemäßen Verfahrens können unter anderem die folgenden Randbedingungen eingestellt werden:
- die Art des Werkstoffes, aus dem die Grundleitschicht der zu behandelnden Materialstücke gebildet ist;
- die Art des Beschichtungsmetalls;
- die Art und die Parameter des elektrolytischen Prozesses, beispielsweise die Stromdichte;
- die Zusammensetzung der Behandlungsflüssigkeit;
- die Geometrie der Behandlungsvorrichtung, beispielsweise die Breite der Elektrodenräume in Transportrichtung.

Durch eine optimale Wahl von Kombinationen der vorgenannten Parameter kann die elektrolytische Behandlung gesteuert werden. Beispielsweise kann durch Wahl eines bestimmten Metallabscheidungsbades bewirkt werden, daß das bereits abgeschiedene Metall nicht wieder abgeätzt wird, da der Metallauflösungsprozess in diesem Fall gehemmt ist. Gleichfalls kann durch geeignete Wahl eines Ätzbades erreicht werden, daß die Metallabscheidung in diesem Bad gehemmt wird.

Um das Verfahren zum Ätzen von Metalloberflächen auf den Materialstücken durchzuführen, werden die Materialstücke zuerst an mindestens einer anodisch gepolten und danach an mindestens einer kathodisch gepolten Elektrode vorbeigeführt.

Das Verfahren und die Vorrichtung können zur Metallisierung von ganzflächigen Metallschichten eingesetzt werden, wobei die Materialstücke zuerst an mindestens einer kathodisch gepolten und danach an mindestens einer anodisch gepolten Elektrode vorbeigeführt werden. Ebenso ist es im Gegensatz zu vielen bekannten Verfahren und Vorrichtungen problemlos möglich, Metall auf mit elektrisch zueinander isolierten Metallinseln versehenen Materialstücken abzuscheiden. Zum elektrolytischen Metallisieren werden vorzugsweise Materialstücke eingesetzt, die mit einer beim elektrolytischen Metallisieren unlöslichen Oberfläche versehen sind. Beispielsweise können mit dem erfindungsgemäßen Verfahren und der Vorrichtung Endschichten aus Metall auf Leiterplatten und Leiterfolien, beispielsweise eine Zinnschicht auf Kupfer, gebildet werden.

Eine weitere vorteilhafte Anwendung des Verfahrens und der Vorrichtung besteht darin, daß die üblicherweise etwa 18 µm dicke außenliegende Kupferschicht auf Leiterplattenmaterial vor der Weiterverarbeitung abgedünnt wird. Ein beispielsweise mit einer lediglich 3 bis 5 µm dicken Kupferschicht überzogenes Leiterplattenmaterial ist hervorragend zur Herstellung von Feinstleiterschaltungen geeignet. Dadurch verringert sich beim Laserbohren und beim Ätzen im Leiterplatten-Herstellprozess der Aufwand. Die Bildung einer derart dünnen Kupferschicht mit dem erfindungsgemäßen Verfahren und der Vorrichtung durch Metallisierung ist problemlos möglich. Auch ein Abtrag von Kupfer von einer Kupferschicht mit einer größeren Schichtdicke durch Ätzen kann qualitativ und wirtschaftlich sinnvoll sein. Durch Bildung der dünneren Kupferschichten wird vermieden, daß die Kupferstrukturen beim anschließenden Ätzprozess unterätzt werden. Dieses Verfahren und die Vorrichtung bieten gegenüber der herkömmlichen Technik erhebliche Vorteile, da sich derartige Materialien nur schwer mit den herkömmlichen Verfahren und Vorrichtungen produzieren lassen. In diesem Falle müssen nämlich entsprechend dünne und sehr teure Kupferfolien gehandhabt werden.

Eine weitere Anwendung des Verfahrens und der Vorrichtung besteht darin, Leiterplatten- und Leiterfolienmaterial nach dem Bohren durch elektrolytisches Ätzen zu entgraten. Hierzu werden bis heute Vorrichtungen eingesetzt, die auf mechanischen Verfahren beruhen, beispielsweise rotierende Bürsten, mit denen der Grat entfernt wird. Derartige mechanische Verfahren sind für Folienmaterialien allerdings überhaupt nicht einsetzbar, da die Folienmaterialien durch die mechanische Behandlung zerstört werden würden.

Das Prinzip des erfindungsgemäßen Verfahrens und der Vorrichtung wird nachfolgend an Hand von
- **Fig. 1:**: schematische Darstellung der erfindungsgemäßen Vorrichtung; und
- **Fig. 2:**: schematische Darstellung des Prinzips des erfindungsgemäßen Verfahrens
erläutert.

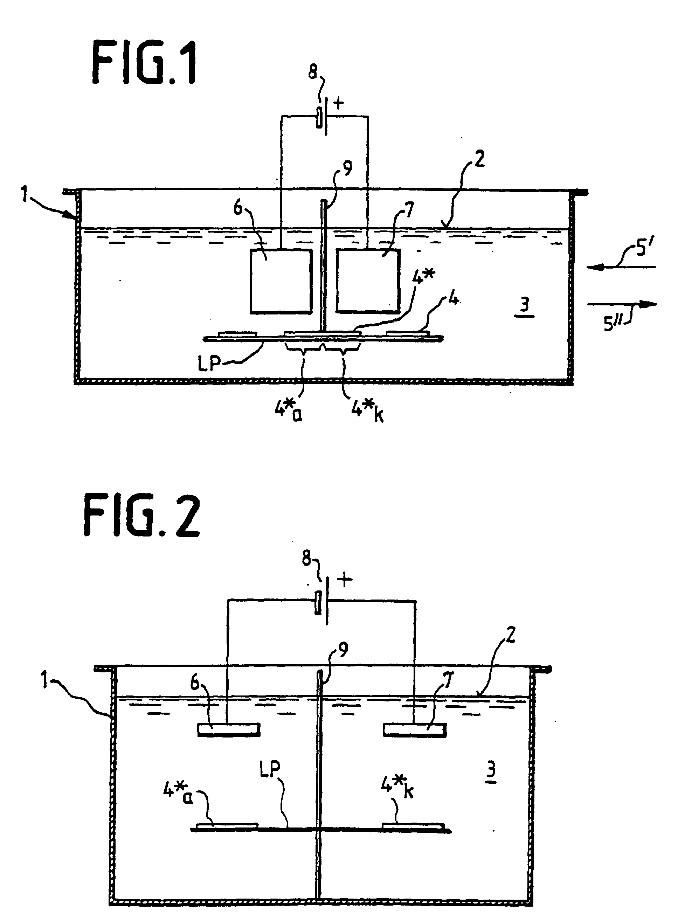

In **Fig. 1** ist ein Badbehälter **1** gezeigt, der bis zum Niveau **2** mit einer geeigneten Behandlungsflüssigkeit **3** gefüllt ist. Ein Leiterplatten- oder Leiterfolienmaterialstück **LP**, beispielsweise ein mit Leiterzugstrukturen **4** und mit Bohrungen versehenes und bereits metallisiertes Mehrschichtlaminat (Multilayer), wird mit geeigneten Transportmitteln, wie beispielsweise Rollen oder Walzen (nicht gezeigt) in horizontaler Richtung **5'** oder **5"** durch die Behandlungsflüssigkeit **3** hindurchgeführt. Im Badbehälter befinden sich ferner zwei Elektroden **6** und **7**, die mit einer Strom/Spannungsquelle **8** verbunden sind. Die Elektrode **6** ist kathodisch gepolt, die Elektrode **7** anodisch. Zwischen den beiden Elektroden **6,7** ist eine Isolierwand **9** (beispielsweise aus Kunststoff) angeordnet, die die beiden Elektroden quer zur Transportrichtung elektrisch gegeneinander abschirmt. Diese Wand **9** wird vorzugsweise so dicht an das Materialstück **LP** herangeführt, daß sie es während des Passierens berührt oder daß sie zumindest an das Materialstück **LP** heranreicht.

Während das Materialstück **LP** an den Elektroden **6,7** vorbeibewegt wird, wird es polarisiert, und zwar in den Bereichen **4***_{**a**} anodisch, die der kathodisch gepolten Elektrode **6** gegenüberliegen, und in den Bereichen **4***_{**k**} kathodisch, die der anodischen Elektrode **7** gegenüberliegen.

Wird das Materialstück **LP** beispielsweise in der Richtung **5'** an den Elektroden **6,7** vorbeigeführt, so werden die Strukturen **4** geätzt: In diesem Fall wird der linke Bereich **4***_{**a**} der Struktur **4*** in der in **Fig. 1** gezeigten Position anodisch gepolt, so daß Metall von der Leiterzugstruktur abgeätzt wird. Der rechte Bereich **4***_{**k**} dieser Struktur **4*** ist dagegen zur anodisch gepolten Elektrode **7** hin ausgerichtet und daher negativ gepolt. Wenn die Behandlungsflüssigkeit **3** keine weiteren elektrochemisch aktiven Redoxpaare enthält, wird in diesem Bereich **4***_{**k**} Wasserstoff entwickelt. In der Summe wird also Metall von den Strukturen **4** abgelöst. Dieser Vorgang läuft bei einer einzelnen Struktur **4** solange ab, wie sich diese Struktur gleichzeitig in den Wirkbereichen der beiden entgegengesetzt gepolten Elektroden **6** und **7** befindet.

Falls das Materialstück **LP** metallisiert werden soll, muß es in Richtung **5"** transportiert werden. In diesem Fall wird ein Metallisierungsbad als Behandlungsflüssigkeit **3** eingesetzt. Zuerst tritt die rechte Kante des Materialstücks **LP** in den Bereich der kathodisch gepolten Elektrode **6** und danach in den Bereich der anodisch gepolten Elektrode **7** ein. Der rechte Teil **4***_{**k**} der Struktur **4*** liegt in der in **Fig. 1** gezeigten Position der anodisch gepolten Elektrode 7 gegenüber und wird daher kathodisch gepolt. Dagegen liegt der linke Teil **4***_{**a**} der Struktur **4*** der kathodisch gepolten Elektrode **6** gegenüber, so daß dieser Teil anodisch gepolt wird. Ist beispielsweise eine Leiterzugstruktur, die aus Kupfer als Grundleitschicht besteht, mit Zinn aus einem Zinnionen enthaltenden wäßrigen Verzinnungsbad **3** zu behandeln, so wird am linken Teil **4***_{**a**} der Struktur **4*** lediglich Sauerstoff entwickelt. Am rechten Teil **4***_{**k**} wird dagegen Zinn abgeschieden. In der Summe scheidet sich daher Zinn auf den Kupferstrukturen ab.

In **Fig. 2** ist dieselbe Anordnung, wie in **Fig. 1** beschrieben, mit einem Badbehälter **1** mit Elektrolytflüssigkeit **3** gezeigt. Das Niveau der Flüssigkeit **3** ist mit der Bezugsziffer **2** bezeichnet. Zusätzlich zu **Fig. 1** wird hier die Wirkung des elektrischen Feldes der Elektroden **6** und **7** auf das Materialstück **LP** schematisch wiedergegeben. Zwischen den Elektroden **6** und **7** befindet sich eine Isolierwand **9**. Die metallischen Strukturen **4***_{**a**} und **4***_{**k**} sind elektrisch miteinander verbunden. An der metallischen Struktur **4***_{**a**}**,** die der kathodisch gepolten Elektrode **6** gegenüberliegt, entsteht ein positiveres Potential, so daß dieser Bereich der Struktur anodisch gepolt ist. An der Struktur **4***_{**k**} entsteht durch die gegenüberliegende, anodisch gepolte Elektrode **7** ein negativeres Potential an der Struktur, so daß dieser Bereich kathodisch gepolt wird. In der gezeigten Anordnung wird die Struktur **4***_{**k**} metallisiert, wenn die Elektrolytflüssigkeit **3** ein Metallisierungsbad ist. Gleichzeitig findet an der anodisch gepolten Struktur **4***_{**a**} ein anodischer Prozess statt. Falls die Elektrolytflüssigkeit **3** ein Verzinnungsbad ist und die Strukturen aus Kupfer bestehen, wird Kupfer nicht aufgelöst. Statt dessen wird an der Struktur **4***_{**a**} Sauerstoff entwickelt.

Als Elektroden können beim elektrolytischen Prozess sowohl lösliche als auch unlösliche Elektroden eingesetzt werden. Lösliche Elektroden werden üblicherweise in Metallisierungsverfahren eingesetzt, um das bei der Metallisierung verbrauchte Metall in der Metallisierungslösung durch Auflösung wieder nachzubilden. Daher werden Elektroden aus dem Metall verwendet, das abgeschieden werden soll. Unlösliche Elektroden sind in der Behandlungsflüssigkeit auch bei Stromfluß inert. Beispielsweise können Blei-, platinierte Titan-, mit Iridiumoxid beschichtete Titan- oder Edelmetallelektroden eingesetzt werden.

Werden das Verfahren und die Vorrichtung zum elektrolytischen Metallisieren eingesetzt, so wird ein Metallionen enthaltendes Metallisierungsbad eingesetzt. Bei Verwendung von löslichen, anodisch gepolten Elektroden werden die Metallionen durch Auflösung dieser Elektroden nachgeliefert. Werden dagegen unlösliche Elektroden eingesetzt, so müssen die Metallionen entweder durch separate Zugabe von geeigneten Chemikalien ergänzt werden, oder es wird beispielsweise die in WO 9518251 A1 beschriebene Vorrichtung eingesetzt, bei der Metallteile durch im Metallisierungsbad enthaltene zusätzliche Ionen eines Redoxpaares aufgelöst werden. In den Kupferbädern ist in diesem Fall ein Fe²⁺/Fe³⁺- oder ein anderes Redoxpaar enthalten.

In einer weiteren Verfahrens- und Vorrichtungsvariante können die Elektroden einer Elektrodenanordnung derart angeordnet werden, daß sie nur auf eine Seite der Materialstücke ausgerichtet sind. Um in diesem Falle einen direkten Stromfluß zwischen den beiden Elektroden zu vermeiden, ist es vorteilhaft, zwischen den Elektroden mindestens eine Isolierwand (etwa aus einer 50 µm dicken Polyimidfolie) anzuordnen, die sehr dicht an die Materialstücke herangeführt wird. Die Isolierwände sind vorzugsweise derart angeordnet, daß sie die Materialstücke beim Transport durch das Elektrolysebad berühren oder daß sie zumindest unmittelbar an die Oberflächen der Materialstücke heranreichen. Dadurch wird eine besonders gute Abschirmung der anodischen Elektrode von der kathodischen Elektrode erreicht.

Da kleine zu metallisierende Strukturen zur elektrolytischen Behandlung sowohl mindestens einer kathodischen als auch mindestens einer anodischen Elektrode gegenüber liegen müssen, darf der Abstand zwischen den Elektroden bei einer festgelegten Größe der Strukturen einen bestimmten Wert nicht überschreiten. Dadurch wird auch eine Obergrenze für die Dicke der Isolierwand festgelegt. Als Faustregel kann angenommen werden, daß die Dicke der Isolierwand maximal etwa der Hälfte der Ausdehnung der zu metallisierenden Strukturen entsprechen soll, wobei vorzugsweise jeweils die Abmessungen in der Transportrichtung des Materials zu vergleichen sind. Bei etwa 100 µm breiten Strukturen sollte die Dicke der Isolierwand 50 µm nicht überschreiten. Bei schmaleren Strukturen sind entsprechend dünne Isolierwände einzusetzen.

Zwischen den einzelnen Elektrodenanordnungen können außerdem weitere Isolierwände vorgesehen sein, um einen direkten Stromfluß zwischen den Elektroden weiterer hintereinander angeordneter Elektrodenanordnungen zu vermeiden.

In einer alternativen Verfahrens- und Vorrichtungsvariante können die Elektroden einer Elektrodenanordnung auch derart angeordnet sein, daß sie auf unterschiedliche Seiten der Materialstücke ausgerichtet sind. In diesem Fall wirken die Materialstücke selbst als Isolierwände zwischen den Elektroden, so daß auf die Verwendung anderer Isolierwände zwischen den Elektroden einer Elektrodenanordnung verzichtet werden kann, wenn die Elektroden nicht über die Materialstücke hinausragen. Diese Verfahrens- und Vorrichtungsvariante kann dann angewendet werden, wenn die elektrisch leitfähigen Bereiche auf den beiden Seiten der Materialstücke elektrisch miteinander verbunden sind.

Diese Anordnung ist beispielsweise für die Behandlung von durchkontaktierten, einseitig funktionellen Leiterplatten und -folien geeignet. Dadurch daß beispielsweise Materiaistücke mit einer ganzflächigen, elektrisch leitfähigen Schicht auf der der Funktionsseite gegenüberliegenden Seite verwendet werden, kann die kathodisch gepolte Elektrode dieser leitfähigen Schicht gegenüber angeordnet werden und die anodisch gepolte Elektrode der Funktionsseite, um Metall auf den Leiterstrukturen der Funktionsseite abzuscheiden. Gleichzeitig wird Metall von der gegenüberliegenden leitfähigen Schicht abgelöst.

Bei Durchführung des erfindungsgemäßen Verfahrens wird darauf geachtet, daß ein direkter Stromfluß zwischen den kathodisch gepolten Elektroden und den anodisch gepolten Elektroden einer Elektrodenanordnung nicht fließen kann. Hierzu können entweder die vorgenannten Isolierwände oder die Materialstücke selbst dienen, wenn die entgegengesetzt gepolten Elektroden einer Elektrodenanordnung auf unterschiedliche Seiten der Materialstücke ausgerichtet sind. Eine dritte Möglichkeit zur Vermeidung eines direkten Stromflusses besteht dann, wenn die Materialstücke nicht in die Behandlungsflüssigkeit eingetaucht, sondern mittels geeigneter Düsen mit der Flüssigkeit in Kontakt gebracht werden. In diesem Fall kann auf die Isolierwände zwischen den auf eine Seite der Materialstücke ausgerichteten Elektroden einer Elektrodenanordnung ganz verzichtet werden, wenn die Flüssigkeitsbereiche, die mit den einzelnen Elektroden in Kontakt stehen, nicht untereinander in Kontakt stehen.

Eine Elektrodenanordnung kann sich senkrecht oder schräg zur Transportrichtung der Materialstücke in der Behandlungsanlage vorzugsweise über die gesamte Behandlungsbreite der Transportebene erstrecken. Die in Transportrichtung gesehene räumliche Ausdehnung der Elektrodenanordnungen wirkt sich in entscheidender Weise auf die Dauer der elektrolytischen Behandlung aus. Für eine vollflächige Behandlung können lange Elektrodenanordnungen eingesetzt werden. Bei der Behandlung von sehr feinen Strukturen müssen dagegen sehr kurze Elektrodenanordnungen eingesetzt werden.

Unter Bezugnahme auf **Fig. 1** kann dies näher erklärt werden: Werden die Materialstücke **LP** von links nach rechts bewegt (Transportrichtung **5"**; Fall: Galvanisierung), wird die vorlaufende rechte Kante einer Struktur **4*** länger galvanisiert als die nachlaufenden Bereiche der Struktur. Dadurch wird eine ungleichmäßige Schichtdicke erhalten. Die maximale Dicke der Schicht hängt im wesentlichen von der Länge der Elektrodenanordnung in Transportrichtung **5',5",** ferner von der Transportgeschwindigkeit, der Stromdichte und den Abmessungen der Strukturen **4** in Transportrichtung **5',5"** ab. In Transportrichtung **5',5"** lange Elektrodenanordnungen und zugleich lange Strukturen **4** führen, absolut gemessen, zu großen Schichtdickenunterschieden bei großer Anfangsschichtdicke. Mit geringerer Länge der Elektrodenanordnungen in Transportrichtung **5',5"** werden die Schichtdickenunterschiede geringer. Gleichzeitig nimmt die Behandlungszeit ab. Die Dimensionierung der Elektrodenanordnungen ist daher dem Bedarf anzupassen. Bei feinsten Leiterzugstrukturen, beispielsweise 0,1 mm großen Pads oder 50 µm breiten Leiterzügen, soll die Länge der Elektrodenanordnungen im unteren Millimeter-Bereich liegen.

Um die Verfahrenswirkung zu vervielfachen, können mindestens zwei Elektrodenanordnungen in einer Behandlungsanlage vorgesehen werden, an denen die Materialstücke nacheinander vorbeigeführt werden. Die Elektroden dieser Elektrodenanordnungen können langgestreckt ausgebildet und im wesentlichen parallel zur Transportebene angeordnet sein. Die Elektroden können sowohl im wesentlichen senkrecht zur Transportrichtung ausgerichtet sein oder einen Winkel α ≠ 90° mit der Transportrichtung bilden. Sie erstrecken sich vorzugsweise über die gesamte Breite der von den Materialstücken eingenommenen Transportebene.

Mit einer Anordnung, bei der die Elektroden einen Winkel α ≠ 90° mit der Transportrichtung bilden, wird erreicht, daß sowohl parallel zur Transportrichtung als auch senkrecht dazu ausgerichtete elektrisch isolierte Metallstrukturen der gewünschten elektrolytischen Reaktion länger ausgesetzt werden, als wenn α ≈ 90° (± 25°). Wäre der Winkel α ≈ 90°, so würden in Transportrichtung ausgerichtete Leiterzüge bei gegebener Transportgeschwindigkeit und gegebener Elektrodenlänge ausreichend lange elektrolytisch behandelt, während senkrecht dazu ausgerichtete Leiterzüge nur kurzzeitig in der Elektrodenanordnung behandelt würden. Dies liegt daran, daß eine elektrolytische Behandlung nur solange möglich ist, wie die Struktur gleichzeitig der anodisch gepolten und der kathodisch gepolten Elektrode einer Elektrodenanordnung gegenüberliegt. Bei Strukturen, die parallel zur Elektrodenanordnung und damit zu den Elektroden ausgerichtet sind, ist diese Kontaktzeit kurz. Umgekehrtes gilt für den Fall, daß die Elektrodenanordnungen parallel zur Transportrichtung ausgerichtet sind (α ≈ 0° (± 25°)).

Die erfindungsgemäße Vorrichtung kann auch mehrere Elektrodenanordnungen mit langgestreckt ausgebildeten Elektroden aufweisen, wobei die Elektroden unterschiedlicher Elektrodenanordnungen unterschiedliche Winkel mit der Transportrichtung bilden. Insbesondere ist eine Anordnung von mindestens zwei langgestreckten Elektrodenanordnungen vorteilhaft, wobei der Winkel zwischen den Elektrodenanordnungen und der Transportrichtung der Materialstücke in der Behandlungsanlage α ≠ 90° ist und die Elektrodenanordnungen etwa senkrecht zueinander angeordnet sind. Vorzugsweise ist α₁ ≈ 45° (erste Elektrodenanordnung), insbesondere 20° bis 70°, und α₂ ≈ 135° (zweite Elektrodenanordnung), insbesondere 110° bis 160°.

In einer besonders bevorzugten Verfahrensweise werden die Elektroden im wesentlichen parallel zur Transportebene oszillierend bewegt.

Ferner können auch mehrere parallel zueinander angeordnete, benachbarte Elektrodenanordnungen mit langgestreckt ausgebildeten Elektroden und jeweils dazwischen angeordneten Isolierwänden vorgesehen sein und benachbarte Elektroden jeweils von einer separaten Strom/Spannungsquelle gespeist werden. In diesem Falle wird dann, wenn beispielsweise eine Metallisierungslösung eingesetzt wird, zuerst Metall auf den isolierten Strukturen der Materialstücke abgeschieden. Da sich die während des Transportes voranlaufenden Bereiche der Strukturen länger im Metallisierungsbereich befinden als die nachlaufenden Strukturen, ist die Metallschichtdicke auf ersteren größer. Passieren die Materialstücke dann die zweite Elektrodenanordnung, bestehend aus der zweiten Elektrode in der ersten Anordnung oder einer dritten Elektrode und einer weiteren entgegengesetzt gepolten Elektrode in der zweiten Anordnung, so wird viel Metall von den voranlaufenden Bereichen der Materialstücke wieder abgelöst und auf den nachlaufenden Strukturen mehr Metall abgeschieden als abgelöst. Somit ergibt sich in der Summe bei der Behandlung in den zwei Elektrodenanordnungen eine Vergleichmäßigung der Metallschichtdicke auf den Strukturen.

Um mit dieser Anordnung eine besonders gleichmäßige Metallschichtdicke zu erreichen, kann die Stromdichte an den der ersten Elektrodenanordnung gegenüberliegenden Strukturen auf einen Wert eingestellt werden, der etwa doppelt so groß ist wie die Stromdichte an den der zweiten Elektrodenanordnung gegenüberliegenden Strukturen.

In einer weiteren bevorzugten Verfahrensweise können die Materialstücke nach dem Vorbei-Führen an mindestens einer Elektrodenanordnung auch um 180° um eine auf der Transportebene senkrecht stehende Achse gedreht und derselben oder einer weiteren Elektrodenanordnung zugeführt werden. Dadurch ergibt sich eine gleichmäßigere Schichtdickenverteilung bei der elektrolytischen Behandlung von beliebig ausgerichteten Strukturen.

In einer weiteren bevorzugten Verfahrensweise können die Elektrodenanordnungen ferner von Isolierwänden umgeben werden. Falls mehrere benachbarte Elektrodenanordnungen eingesetzt werden, werden diese Isolierwände zwischen den Elektrodenanordnungen angeordnet. Durch diese die Elektrodenanordnungen umgebenden Isolierwände und die zwischen den Elektroden angeordneten Isolierwände werden zur Transportebene hin gerichtete Öffnungen gebildet.

Diese Öffnungen können je nach den gestellten Anforderungen unterschiedlich große Weiten aufweisen. Beispielsweise weisen diese Öffnungen in Transportrichtung gesehen jeweils eine derartige Weite auf, daß die den kathodisch gepolten Elektroden zugeordneten Öffnungen kleiner sind als die den anodisch gepolten Elektroden zugeordneten Öffnungen, wenn das Verfahren zum Abscheiden von Metall auf den Materialstücken angewendet wird, oder daß die den kathodisch gepolten Elektroden zugeordneten Öffnungen größer sind als die den anodisch gepolten Elektroden zugeordneten Öffnungen, wenn das Verfahren zum Ätzen von Metalloberflächen auf den Materialstücken angewendet wird.

Mit dieser Ausführungsform wird erreicht, daß die Stromdichte an den den kathodisch gepolten Elektroden gegenüberliegenden Bereichen auf den zu behandelnden Materialstücken verschieden ist von der Stromdichte an den den anodisch gepolten Elektroden gegenüberliegenden Bereichen. Durch diese Unterschiede können unterschiedlich große Potentiale an diesen Bereichen eingestellt werden, um bestimmte Elektrolyseprozesse zu begünstigen und andere zurückzudrängen. Damit ist es beispielsweise möglich, die Abscheidung von Metall gegenüber der konkurrierenden Auflösung des Metalls zu beschleunigen, um auf diese Weise auch Metalle in größerer Dicke auf die Materialstücke abzuscheiden. Dadurch daß in dem genannten Falle die Stromdichte und damit das Potential an dem der kathodisch gepolten Elektrode gegenüberliegenden Bereich auf den Materialstücken erhöht wird, läuft dort als konkurrierende Reaktion die Wasserzersetzung (Sauerstoffentwicklung) ab. Dadurch wird weniger Metall aufgelöst als an den zu den anodisch gepolten Elektroden korrespondierenden Materialoberflächen Metall abgeschieden wird. Umgekehrtes gilt natürlich für die Anwendung, bei der Metall geätzt wird.

Um Metallabscheidung auf den kathodisch gepolten Elektroden zu verhindern, können diese mit ionensensitiven Membranen abgeschirmt werden, so daß Elektrolyträume gebildet werden, die die kathodisch gepolten Elektroden umgeben. Falls keine ionensensitiven Membranen eingesetzt werden, muß auf den kathodisch gepolten Elektroden abgeschiedenes Metall im Tages- oder Wochenrhythmus wieder entfernt werden. Hierzu kann beispielsweise eine kathodisch gepolte Flächenelektrode zur Entmetallisierung dieser Elektroden angeordnet werden, wobei die metallisierten Elektroden in diesem Falle anodisch gepolt werden. Diese Entmetallisierungselektroden können in Produktionspausen anstelle der zu behandelnden Materialstücke in die Elektrodenanordnung eingebracht werden. Sehr einfach ist auch ein zyklischer Tausch mit externer Entmetallisierung der kathodisch gepolten Elektroden.

Zur Behandlung der Materialstücke kann es ferner vorteilhaft sein, die an die Elektroden der Elektrodenanordnungen angelegte elektrische Spannung derart zu modulieren, daß eine unipolare oder bipolare Strompulsfolge an den Elektroden fließt.

Die nachfolgenden Figuren dienen zur weiteren Erläuterung der Erfindung. Es zeigen im einzelnen:

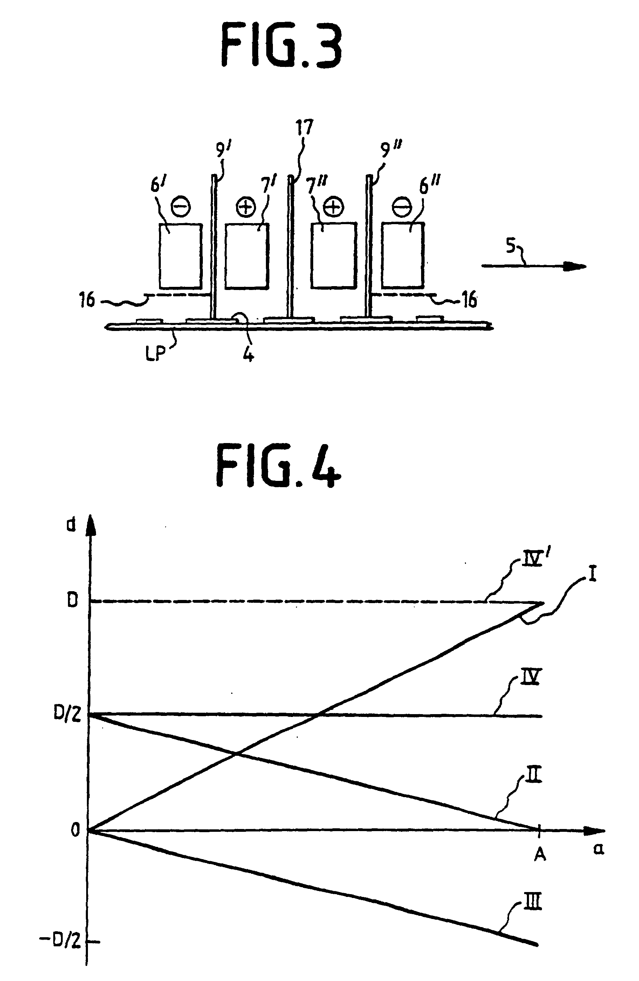

- **Fig. 3:**: eine schematische Darstellung des Aufbaus einer Elektrodenanordnung;
- **Fig. 4:**: den Schichtdickenverlauf einer Struktur nach Behandlung in der Vorrichtung nach **Fig. 3**;

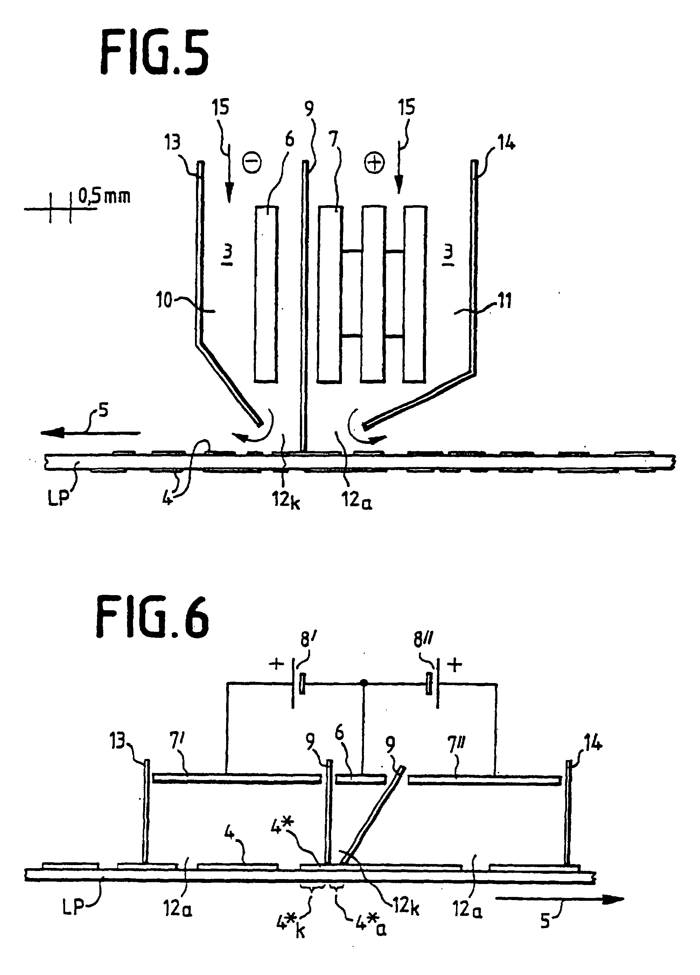

- **Fig. 5:**: eine schematische Darstellung von zwei Elektroden einer Elektrodenanordnung;
- **Fig. 6:**: eine schematische Darstellung von mehreren Elektroden, die unterschiedlichen Elektrodenanordnungen angehören;

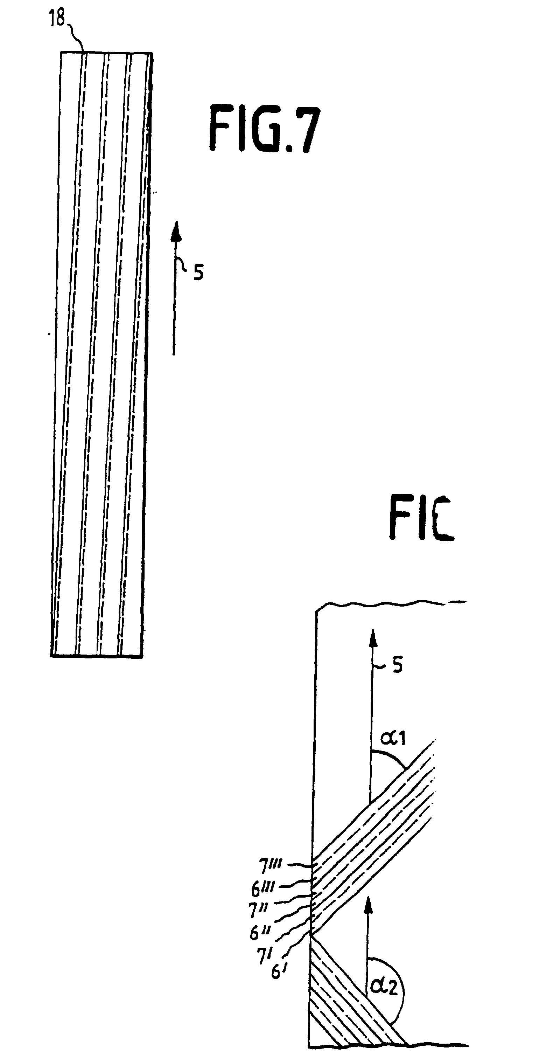

- **Fig. 7:**: eine spezielle Anordnung von mehreren Elektrodenanordnungen entlang des Transportweges für die Materialstücke in einer Durchlaufanlage;

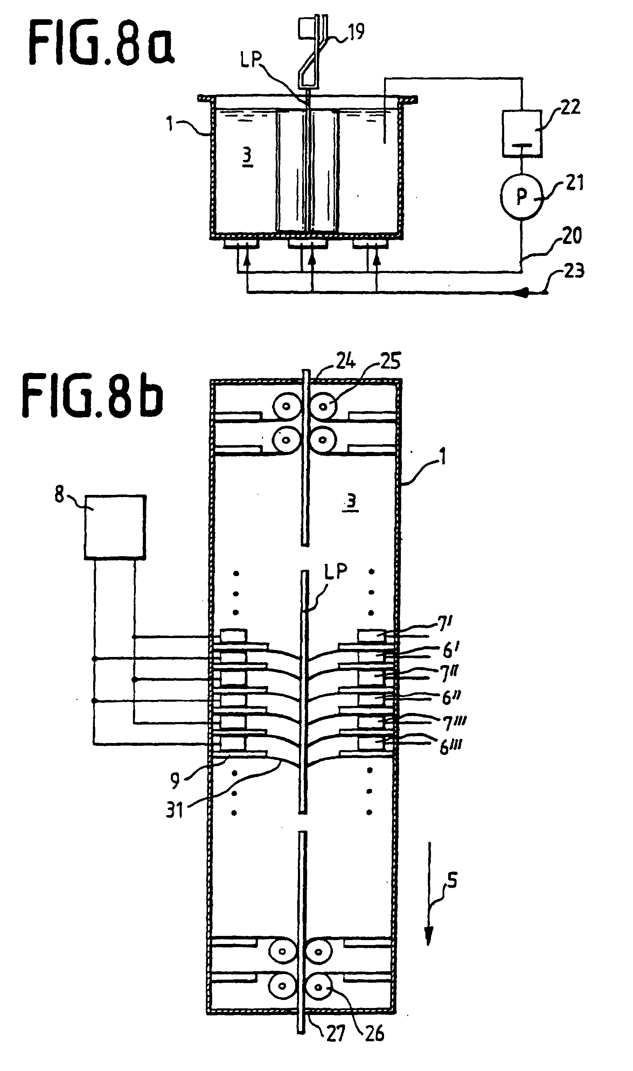

- **Fig. 8a:**: einen Schnitt durch eine Durchlaufanlage mit vertikaler Transportebene;
- **Fig. 8b**:: eine Draufsicht auf eine Durchlaufanlage mit vertikaler Transportebene;

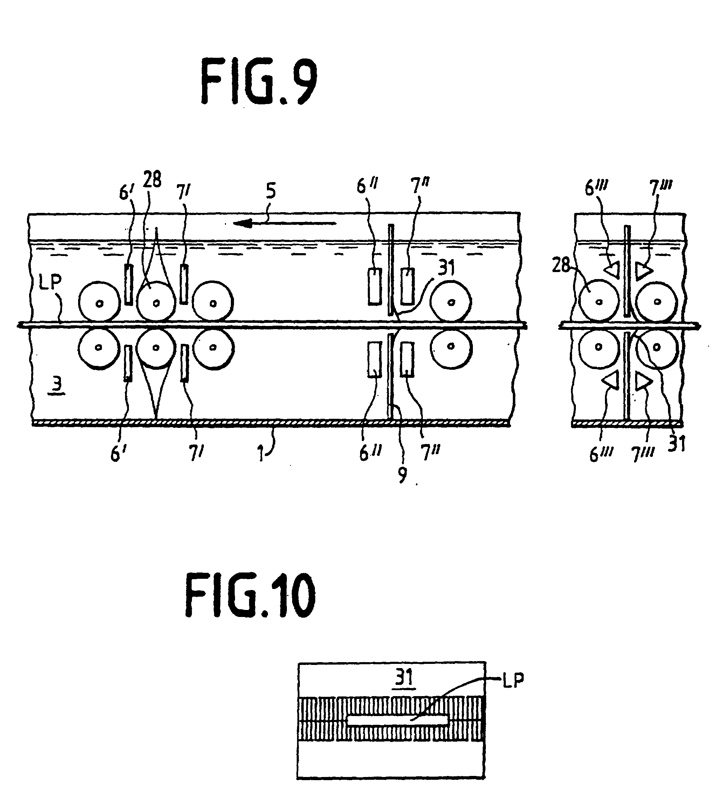

- **Fig. 9:**: einen seitlichen Schnitt durch eine Durchlaufanlage, bei der die Materialstücke in einer horizontalen Transportebene transportiert werden; **Fig. 10:** eine schematische Darstellung einer Dichtfolie in Vorderansicht;

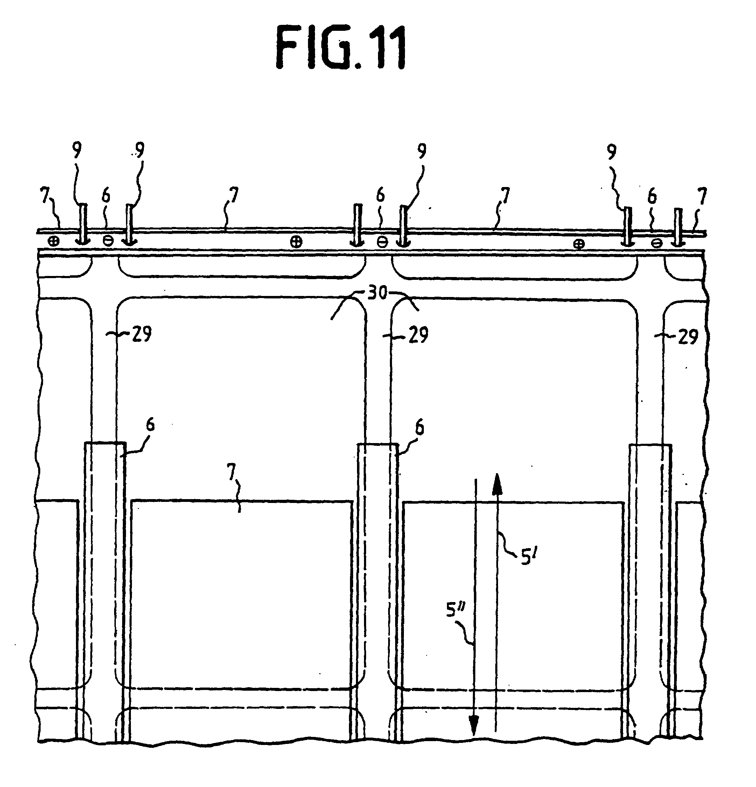

- **Fig. 11:**: eine Draufsicht auf ein Materialstück mit Kupferstrukturen und Projektion der Elektroden von mehreren Elektrodenanordnungen;
- **Fig. 12:**: eine weitere spezielle Anordnung von mehreren Elektrodenanordnungen entlang des Transportweges für die Materialstücke in einer Durchlaufanlage.

Eine Elektrodenanordnung gemäß den **Fig. 1** und **2** eignet sich hervorragend zur Behandlung von großflächigen Metalloberflächen. Die Länge der Elektroden in Transportrichtung bestimmt zusammen mit der Transportgeschwindigkeit die Dauer der elektrolytischen Behandlung mit einer Elektrodenanordnung. Bei großen zu behandelnden Flächen oder großen Strukturen wird eine große Elektrodenlänge in Transportrichtung gewählt, zumindest soweit dies die prozeßbestimmende Elektrode betrifft.

Wird durch geeignete Prozeßparameter dafür gesorgt, daß durch die Behandlung an der zweiten Elektrode einer Elektrodenanordnung der an der ersten Elektrode zunächst erzielte Behandlungseffekt nicht oder zumindest nicht in wesentlichem Umfange wieder rückgängig gemacht wird, so können mehrere erfindungsgemäße Elektrodenanordnungen in Transportrichtung hintereinander angeordnet werden, d.h. ein Materialstück wird nacheinander an mehreren Elektrodenanordnungen vorbeigeführt. Die jeweiligen Behandlungsergebnisse, die mit den einzelnen Elektrodenanordnungen erreicht werden, summieren sich. Die Länge der Elektrodenanordnungen in Transportrichtung muß an die Größe der zu behandelnden Strukturen angepaßt werden. Bei der Behandlung kleiner Strukturen muß diese Länge auch klein gewählt werden. Die Anzahl der Elektrodenanordnungen muß bei einem geforderten Behandlungsergebnis entsprechend größer gewählt werden. Voraussetzung ist stets, daß das Behandlungsergebnis durch die jeweils nachfolgende Elektrode einer Elektrodenanordnung nicht wieder rückgängig gemacht wird. Beispielsweise soll eine bereits aufgebrachte Metallschicht beim Passieren einer nachfolgenden kathodisch gepolten Elektrode nicht wieder entfernt werden.

Bei sehr kleinen zu behandelnden Strukturen tritt die Behandlung der Randbereiche von zu behandelnden Strukturen, die zuerst bzw. zuletzt an den Elektroden vorbeigeführt werden, in den Vordergrund. Allerdings sollen auch diese Randbereiche möglichst gleichmäßig elektrolytisch behandelt werden. Hierzu wird die Möglichkeit, in der Elektrodenanordnung elektrochemisch "gegenläufige" Reaktionen (beispielsweise metallisieren, entmetallisieren) gezielt einstellen zu können, vorteilhaft eingesetzt. Anhand von **Fig. 3** wird das sehr gleichmäßige elektrolytische Behandeln auch kleinster Strukturen (Breite 0,1 mm) beschrieben.

In **Fig. 3** ist eine Anordnung mit zwei Elektrodenanordnungen mit jeweils anodisch und kathodisch gepolten Elektroden **6',7',6",7"** wiedergegeben. Ein Materialstück **LP** mit den Strukturen **4**, beispielsweise Leiterzugstrukturen aus Kupfer, wird in Transportrichtung **5** durch eine hier nicht dargestellte Elektrolytflüssigkeit hindurchgeführt. Als Elektrolytflüssigkeit wird in diesem Beispiel ein Verzinnungsbad eingesetzt.

Die kathodisch gepolten Elektroden **6',6"** sind durch ionensensitive Diaphragmen **16** von dem umgebenden Elektrolytraum abgeschirmt. Dadurch wird die Abscheidung von Zinn auf den Elektroden **6',6"** aus der Elektrolytflüssigkeit verhindert. Zwischen den Elektroden **6'** und **7'** bzw. **6"** und **7"** befinden sich jeweils Isolierwände **9'** bzw. **9"**. Zwischen den beiden Elektrodenanordnungen ist eine Isolierwand **17** angeordnet. Die Diaphragmen **16** können auch entfallen. In diesem Falle sind die kathodisch gepolten Elektroden von Zeit zu Zeit zu entmetallisieren.

In der ersten Elektrodenanordnung, in der sich die Elektroden **6'** und **7'** befinden, werden die Strukturen **4** metallisiert. Dadurch daß die Strukturen **4** von links nach rechts an der Elektrodenanordnung vorbeigeführt werden, wird der rechte Rand der Strukturen **4** der elektrolytischen Reaktion länger ausgesetzt als der linke Rand, so daß die abgeschiedene Metallmenge und damit die Metallschichtdicke größer ist als am linken Rand. Um dieses Ungleichgewicht zumindest teilweise auszugleichen, wird das Materialstück **LP** nach dem Durchlaufen der ersten Elektrodenanordnung an der zweiten Elektrodenanordnung vorbeigeführt. In dieser Anordnung ist die Reihenfolge der kathodisch gepolten Elektrode **6"** und der anodisch gepolten Elektrode **7"** gegenüber der Polarität der Elektroden **6'** und **7'** in der ersten Elektrodenanordnung vertauscht, so daß jeweils der linke Rand der Strukturen **4** der elektrochemischen (Galvanisier)-Wirkung der Elektrode **7"** länger ausgesetzt ist als der jeweilige rechte Rand. Der rechte Rand der Strukturen **4** wird beim Passieren der kathodisch gepolten Elektrode **6"** anodisch gepolt und damit der anodischen Reaktion länger ausgesetzt als der linke Rand der Strukturen **4**, so daß in diesem Falle Metall bevorzugt am rechten Rand wieder abgelöst wird. Im Ergebnis wird eine weitgehend gleichmäßig dicke Zinnschicht abgeschieden.

Dieses Ergebnis läßt sich mit Hilfe des Diagramms in **Fig. 4** nachvollziehen, in dem die erhaltene Metallschichtdicke d als Funktion der Längenausdehnung a der zu beschichtenden Struktur **4** wiedergegeben ist. Dieses Diagramm wurde unter der Randbedingung erstellt, daß der Strom in der zweiten Elektrodenanordnung halb so groß ist wie in der ersten Elektrodenanordnung und daß die Stromausbeute der elektrochemischen Reaktionen (Metallauflösung, Metallabscheidung) nahe 100% ist.

Die nach Durchlauf des Materialstücks durch die erste Elektrodenanordnung meßbare Schichtdickenverteilung ist mit der Kurve I bezeichnet. Am linken Rand der Strukturen **4** (a = 0) ist praktisch kein Metall abgeschieden worden, während am rechten Rand (a = A) die Schichtdicke D erreicht ist. Beim Passieren der zweiten Elektrodenanordnung finden zwei Prozesse statt: Am linken Rand wird praktisch nur Metall abgeschieden (Teilprozess, dargestellt durch Kurve **II**). Daher wird in diesem Bereich die Schichtdicke D/2 erreicht. Weiterhin wird am rechten Rand praktisch nur Metall abgelöst (Teilprozess, dargestellt durch Kurve **III**). Daher verringert sich die Schichtdicke an dieser Stelle von ursprünglich d = D auf d = D/2. Die dazwischen liegenden Bereiche auf der Struktur weisen ebenfalls im wesentlichen eine Schichtdicke von d = D/2 auf. Die resultierende Schichtdickenverteilung ist in Kurve **IV** angegeben.

Durch Optimierung des Behandlungsbades kann die Metallisierung noch verbessert werden: Indem ein Bad zur Metallabscheidung verwendet wird, das eine Metallauflösung nicht zuläßt, kann insgesamt eine größere Metallschichtdicke erreicht werden. In diesem Falle müssen die Ströme der ersten und der zweiten Elektrodenanordnung gleich groß sein. Die in **Fig. 4** gezeigte Kurve **III** fällt in diesem Falle mit der Abszisse zusammen, da kein Metall aufgelöst wird. Daher wird eine Dicke D der Schicht erhalten, die über die gesamte Oberfläche der Metallstrukturen konstant ist (Kurve **IV'**)

Eine weitere Vereinfachung der Anordnung gemäß **Fig. 3** wird dadurch erreicht, daß die mittleren Bereiche mit den Elektroden **7',7"** zu einem Bereich mit einer Elektrode zusammengefaßt werden. Auch in diesem Falle werden zwei Strom/Spannungsquellen zur Stromversorgung der Elektroden benötigt, mit denen die unterschiedlichen Ströme an die beiden Teil-Elektrodenanordnungen, bestehend aus der Elektrode **6'** und der Elektrode **7',7"** zum einen und aus der Elektrode **7',7"** und der Elektrode **6"** zum anderen, erzeugt werden können. Die Trennwand **17** entfällt in diesem Falle. Der mechanische Aufbau der Elektrodenanordnungen ist in diesem Falle besonders einfach.

In Fig. 5 ist der schematische Aufbau einer Elektrodenanordnung in einer bevorzugten Ausführungsform der Erfindung wiedergegeben. Das Materialstück **LP** mit den Strukturen **4** ist unterhalb der Elektrodenanordnung dargestellt (die an der Unterseite des Materialstücks **LP** liegenden Strukturen **4** werden von einer zweiten Elektrodenanordnung an der Unterseite des Materialstücks elektrolytisch behandelt). Das Materialstück LP wird in der Transportrichtung 5 geführt. Die Elektrodenanordnung besteht aus den Elektroden **6** (kathodisch) und **7** (anodisch). Zwischen den Elektroden **6** und **7** befindet sich eine Isolierwand **9,** die in diesem Falle auf dem Materialstück **LP** aufliegt und eine wirkungsvolle elektrische Abschirmung der Feldlinien, die von den Elektroden **6** und **7** ausgehen, bewirkt. Die Elektroden **6** und **7** sind vom Kathodenraum **10** und Anodenraum **11** umgeben, in dem sich die Elektrolytflüssigkeit **3** befindet. Die beiden Räume **10** und **11** öffnen sich zur Transportebene, in der das Materialstück **LP** geführt wird. Durch zwei kleine Öffnungen **12**_{**k**} und **12**_{**a**}**,** die durch die seitlichen Isolierwände **13,14** und die Isolierwand **9** zwischen den Elektroden **6** und **7** gebildet werden, wird eine Fokussierung der Wirkung der Elektroden auf einen kleinen Bereich des Materialstückes **LP** erreicht. Dies ist vorteilhaft, da dadurch die elektrolytische Behandlung der kleinen Strukturen **4** vergleichmäßigt wird. Im Gegensatz dazu ist die elektrolytische Behandlung von kleinen Strukturen bei Wahl großer Öffnungen **12**_{**a**}**,12**_{**k**} ungleichmäßig.

Wie in **Fig. 5** ebenfalls erkennbar, wird die Elektrolytflüssigkeit **3** von oben in die Elektrodenanordnungen gefördert (dargestellt durch die Pfeile **15**). Durch die hohe Fließgeschwindigkeit kann die elektrochemische Reaktion beschleunigt werden.

In **Fig. 6** ist eine weitere erfindungsgemäße Anordnung mit mehreren benachbarten Elektroden **6,7',7"** gezeigt. Die Elektroden **6,7',7"** sind mit den Strom/Spannungsquellen **8',8",** beispielsweise Galvanogleichrichtern, verbunden. Zwischen den Elektroden befinden sich Isolierwände **9**. Ein zu behandelndes Materialstück **LP** wird in der Transportebene in Transportrichtung **5** bewegt. Die jeweiligen Elektrolyträume, die die Elektroden **6,7** umgeben, weisen zur Transportebene ausgerichtete Öffnungen **12**_{**a**}**,12**_{**k**} auf, die von den Isolierwänden **9** gebildet werden. Diese Öffnungen **12**_{**a**}**,12**_{**k**} sind unterschiedlich groß. Dadurch stellen sich unterschiedlich große Stromdichten und damit auch unterschiedliche Potentiale an den den Öffnungen **12**_{**a**}**,12**_{**k**} gegenüberliegenden Bereichen **4,4*** auf dem Materialstück **LP** ein.

Für den Fall, daß ein mit metallischen Bereichen **4** versehenes Materialstück **LP** in einer Metallabscheidelösung behandelt wird, ergibt sich folgende Situation:

Dadurch daß die Öffnung **12**_{**k**} an der kathodisch gepolten Elektrode **6** kleiner ist als die Öffnung **12**_{**a**} an der anodisch gepolten Elektrode **7**, wird eine höhere Stromdichte und damit ein höheres Potential an den der kathodisch gepolten Elektrode 6 gegenüberliegenden Bereichen **4***_{**a**} eingestellt als an den den anodisch gepolten Elektroden **7',7"** gegenüberliegenden Bereichen **4***_{**k**} des behandelten Bereichs **4*.** Dadurch wird beim anodischen Teilprozess im Bereich der kathodisch gepolten Elektrode **6** zusätzlich zur Metallauflösung auch die konkurrierende Sauerstoffentwicklung stattfinden, so daß weniger Metall in diesem Bereich **4***_{**a**} abgelöst als im Bereich **4***_{**k**} Metall abgeschieden wird. In der Summe wird daher eine Metallschicht gebildet.

In Fig. 7 ist eine spezielle Anordnung von mehreren Elektrodenanordnungen 18 entlang des Transportweges für die Materialstücke in einer Durchlaufanlage in Draufsicht wiedergegeben. Dabei sind die Elektroden in der Anordnung von **Fig. 1** durch die durchgezogenen und die strichlierten Geraden schematisch dargestellt. Die Elektrodenanordnungen **18** sind in Transportrichtung **5** leicht schräg gestellt und erstrecken sich in entsprechender Länge in der elektrolytischen Anlage. Jede Elektrodenanordnung **18** dient nur zur Behandlung eines Teils der Oberfläche der zu behandelnden Materialstücke. Damit wird die Behandlungszeit erheblich verlängert. Weist die elektrolytische Anlage beispielsweise eine Länge von 1,40 m und eine Breite von 0,20 m auf, so ergibt dies bei der dargestellten Anordnung mit vier Elektrodenanordnungen **18** eine Verlängerung der Behandlungszeit von 1400 mm x 4 / 200 mm = 28. Bei einer aktiven Länge einer Elektrodenanordnung **18** von 1 mm ergibt sich somit bei einer Transportgeschwindigkeit von beispielsweise 0,1 m/min eine Behandlungszeit von etwa 17 sec. Bei einer mittleren Abscheidungsstromdichte in Höhe von 10 A/dm² beträgt die Schichtdicke von abgeschiedenem Kupfer etwa 0,6 µm. Werden mehrere Elektroden zur Behandlung von Teilbereichen der Materialstücke eingesetzt, so multipliziert sich die Schichtdicke mit der Anzahl der Elektrodenanordnungen.

In **Fig. 8a** ist eine Durchlaufanlage im Schnitt dargestellt. Die Materialstücke **LP** werden in diesem Fall mit einem Greifmechanismus **19**, beispielsweise einer Klammer, oder hier nicht dargestellten Walzen transportiert und senkrecht gehalten. Die Materialstücke **LP** werden in einen Behälter **1** von der Seite eingeführt, der das Behandlungsbad, beispielsweise eine Metallisierungslösung **3** enthält. Diese Lösung wird über geeignete Rohrleitungen **20** kontinuierlich aus dem Behälter mittels einer Pumpe **21** abgezogen und über einen Filter **22** geführt, bevor sie wieder in den Behälter **1** zurückgefördert wird. Außerdem kann zur Verwirbelung der Lösung **3** im Behälter **1** Luft über eine Rohrleitung **23** eingeleitet werden.

In **Fig. 8b** ist die in **Fig. 8a** gezeigte Anlage in Draufsicht wiedergegeben, wobei die Einbauten nur teilweise dargestellt sind. Die Materialstücke **LP** werden in Transportrichtung **5** geführt. Innerhalb des Behälters 1 befindet sich die Behandlungsflüssigkeit **3**, in diesem Falle eine zum elektrolytischen Ätzen geeignete Lösung. Die Materialstücke **LP** werden über die Öffnung **24** und durch Abquetschwalzen **25** in den Behälter eingeführt und zwischen Abquetschwalzen **26** und die Öffnung **27** hindurch aus dem Behälter wieder hinaus.

Im Behälter 1 befinden sich mehrere hintereinander und beidseits der Transportebene für die Materialstücke **LP** angeordnete Elektrodenanordnungen, die jeweils aus kathodisch gepolten Elektroden **6',6",6''',...** und anodisch gepolten Elektroden **7',7",7''',...** gebildet sind. Zwischen den Elektroden befinden sich Isolierwände **9**. Diese Isolierwände **9** weisen elastische Dichtfolien **31** auf, die eine vollständige Abschirmung der elektrischen Felder der einzelnen Elektrodenräume gegeneinander dadurch ermöglichen, daß sie beim Passieren der Materialstücke LP die Materialoberflächen berühren. Die Elektroden **6',6",6''',...,7',7",7''',...** sind mit einem Galvanogleichrichter **8** verbunden, wobei die Verbindungen der in **Fig. 8b** rechts gezeigten Elektroden mit dem Gleichrichter nicht dargestellt sind. Jede Elektrodenanordnung kann auch von getrennten Gleichrichtern gespeist werden.

Indem die Materialstücke **LP** beispielsweise zuerst an einer anodisch gepolten Elektrode vorbeigeführt werden und dann an einer kathodisch gepolten Elektrode, wird Metall elektrolytisch abgetragen.

In **Fig. 9** ist eine Horizontalanlage (Durchlaufanlage mit horizontaler Transportebene) in seitlichem Schnitt dargestellt. Der Behälter **1** enthält die Behandlungsflüssigkeit **3**. Die zu behandelnden Materialstücke **LP** werden in der Behandlungsflüssigkeit **3** an den Elektrodenanordnungen vorbei in horizontaler Transportrichtung **5** geführt. Die Elektrodenanordnungen bestehen wiederum aus jeweils kathodisch gepolten Elektroden **6',6",6'",...** und anodisch gepolten Elektroden **7',7",7''',....** Die Elektrodenanordnungen sind beidseits der Transportebene, in der die Materialstücke **LP** geführt werden, angeordnet.

Zur Isolierung der Elektroden **6',6",6''',...,7',7",7''',...** gegeneinander werden im vorliegenden Fall Isolierwalzen **28** mit Dichtlippen verwendet. Anstelle der Isolierwaizen **28** können auch Isolierwände **9** mit Dichtfolien **31** eingesetzt werden.

Im rechten Teil von **Fig. 9** ist eine alternative Ausführungsform und Anordnung der Elektroden **6''',7'''** relativ zu den Isolierwänden **9** und Dichtfolien **31** dargestellt.

In **Fig. 10** ist ein Detail einer Isolierung zwischen den Elektroden einer Elektrodenanordnung in Vorderansicht dargestellt. Um eine sichere Abdichtung bei Behandlung von dickeren Leiterplatten **LP** zu erreichen, kann die Dichtfolie **31** an der Isolierwand gefiedert sein. Hierdurch wird vermieden, daß sich seitlich von den durchlaufenden Leiterplatten **LP** Lücken ergeben.

In **Fig. 11** ist eine Draufsicht auf ein strukturiertes Materialstück gezeigt, das in einer Durchlaufanlage transportiert wird, beispielsweise ein Leiterplattenlaminat **LP** mit Metall-Opferbereichen **29** und mit Metallstrukturen versehenen Bereichen **30** (Strukturen nicht gezeigt), die elektrisch miteinander verbunden sind. Dieses Materialstück **LP** kann beispielsweise in einer Horizontalanlage behandelt werden, indem es mit der Behandlungsflüssigkeit in Kontakt gebracht und an den erfindungsgemäßen Elektrodenanordnungen vorbeigeführt wird. Die Elektroden 6,7 der Elektrodenanordnungen sind hier in der Projektion auf das Materialstück LP dargestellt. Die anodisch gepolten Elektroden 7 sind auf die strukturierten Bereiche **30** ausgerichtet und mit "⊕" bezeichnet und die kathodisch gepolten Elektroden **6** auf die aus Metall bestehenden Opferbereiche **29**, wobei diese mit "⊖" bezeichnet sind. Zwischen den Elektroden **6** und **7** sind Isolierwände **9** angeordnet. Die Isolierwände **9** und die Elektroden **6,7** sind in der Darstellung der **Fig. 11** nur angedeutet, wobei es sich bei diesem Detail um eine Schnittdarstellung durch die Zeichenebene von **Fig. 11** handelt.

Das Materialstück wird in einer der Transportrichtungen **5'** und **5"** geführt. Dabei werden die Opferbereiche **29** aus Metall fortwährend an den kathodisch gepolten Elektroden **6** vorbeigeführt und lösen sich daher auf. Die strukturierten Bereiche **30** werden dagegen metallisiert, da sie an den anodisch gepolten Elektroden **7** vorbeigeführt werden. Mit dieser Anordnung ist die Abscheidung eines Metalls möglich, das mit dem Metall identisch ist, aus dem die strukturierten Bereiche **30** bestehen.

In **Fig. 12** ist eine weitere bevorzugte erfindungsgemäße Vorrichtung schematisch dargestellt. Die Materialstücke werden in Transportrichtung **5** an den Elektrodenanordnungen vorbeigeführt, die jeweils aus langgestreckten Elektroden **6',6",6''',...** und **7,'7",7''',...** bestehen. Die Elektrodenanordnungen mit den Elektroden bilden einen Winkel α₁ bzw. einen Winkel α₂ gegenüber der Transportrichtung **5**. Dadurch wird der Einfluß der Behandlungzeit von gegenüber der Transportrichtung **5** unterschiedlich ausgerichteten Strukturen ausgeglichen. Da bei Leiterplatten die Leiterzüge üblicherweise parallel oder senkrecht zu einer Seitenkante der Platten verlaufen und damit parallel oder senkrecht zur Transportrichtung **5**, wird durch die dargestellte Ausrichtung der Elektrodenanordnungen eine gleich lange Behandlungszeit für Leiterzüge beider Ausrichtungen erreicht, soweit diese dieselbe Länge aufweisen.

### Bezugszeichen:

- **1**: Badbehälter
- **2**: Niveau der Behandlungsflüssigkeit **3**
- **3**: Behandtungsflüssigkeit
- **4**: metallische Struktur/Oberfläche auf den Materialstücken **LP**
- **4***: behandelte metallische Struktur **4**
- **4***_{**a**}: anodisch behandelte metallische Struktur **4**
- **4***_{**k**}: kathodisch behandelte metallische Struktur **4**
- **5,5',5"**: Transportrichtung
- **6,6',6",6'''**: kathodisch gepolte Elektroden
- **7,7',7",7'''**: anodisch gepolte Elektroden
- **8,8',8"**: Strom/Spannungsquellen
- **9**: Isolierwand
- **10**: Kathodenraum
- **11**: Anodenraum
- **12**: Öffnung der Elektrodenanordnung zum Badbehälter
- **12**_{**k**}: Öffnung an der kathodisch gepolten Elektrode
- **12**_{**a**}: Öffnung an der anodisch gepolten Elektrode
- **13**: isolierende Seitenwand der Elektrodenanordnung
- **14**: isolierende Seitenwand der Elektrodenanordnung
- **15**: Strömungsrichtung der Behandlungsflüssigkeit **3**
- **16**: Diaphragma
- **17**: Isolierwand zwischen zwei Elektrodenanordnungen
- **18**: Elektrodenanordnung
- **19**: Klammer
- **20**: Elektrolytleitung
- **21**: Pumpe
- **22**: Filter
- **23**: Luftzuleitung
- **24**: Einlauföffnung
- **25**: Abquetschwalze
- **26**: Abquetschwalze
- **27**: Auslauföffnung
- **28**: Isolierwalze
- **29**: Opferbereich
- **30**: strukturierter Bereich
- **31**: Dichtfolie
- **LP**: Platten-/Folienmaterialstück

## Patentansprüche

1. Verfahren zum elektrolytischen Behandeln von elektrisch leitfähigen Oberflächen (**4**) von gegeneinander vereinzelten Platten- und Folienmaterialstücken (**LP**), bei dem die Materialstücke (**LP**)
a. durch eine Behandlungsanlage transportiert und dabei mit Behandlungsflüssigkeit (**3**) in Kontakt gebracht werden;
b. während des Transportes an mindestens einer Elektrodenanordnung, jeweils bestehend aus mindestens einer kathodisch gepolten Elektrode (6) und mindestens einer anodisch gepolten Elektrode (7), vorbeigeführt werden, wobei die mindestens eine kathodisch gepolte Elektrode (6) und die mindestens eine anodisch gepolte Elektrode (**7**) mit der Behandlungsflüssigkeit (**3**) in Kontakt gebracht und mit einer Strom/Spannungsquelle (**8**) verbunden werden, so daß ein Strom durch die Elektroden (**6,7**) und die elektrisch leitfähigen Oberflächen (**4**) fließt,
c. wobei die Elektroden (**6,7**) einer Elektrodenanordnung derart angeordnet werden, daß sie auf eine Seite der Materialstücke (**LP**) ausgerichtet sind, und daß zwischen den Elektroden (**6,7**) mindestens eine Isolierwand (**9**) angeordnet wird

2. Verfahren nach Anspruch 1, **dadurch gekennzeichnet, daß** die mindestens eine Isolierwand (**9**) derart angeordnet wird, daß sie die Materialstücke (**LP**) beim Transport durch die Behandlungsanlage berührt oder daß sie zumindest unmittelbar an die Materialstücke (**LP**) heranreicht.

3. Verfahren nach einem der vorstehenden Ansprüche, **dadurch gekennzeichnet, daß** die Materialstücke (**LP**) nacheinander an mindestens zwei Elektrodenanordnungen vorbeigeführt werden.

4. Verfahren nach einem der vorstehenden Ansprüche, **dadurch gekennzeichnet, daß** die Materialstücke (**LP**) in einer Transportrichtung (**5**) und in einer Transportebene transportiert werden und daß die Elektroden (**6,7**) langgestreckt ausgebildet und im wesentlichen parallel zur Transportebene angeordnet werden.

5. Verfahren nach Anspruch 4, **dadurch gekennzeichnet, daß** sich die Elektroden (**6,7**) im wesentlichen senkrecht zur Transportrichtung (**5**) etwa über die gesamte Breite der Materialstücke (**LP**) erstrecken.

6. Verfahren nach Anspruch 4, **dadurch gekennzeichnet, daß** die Elektroden (**6,7**) einen Winkel α ≠ 90° mit der Transportrichtung (**5**) bilden.

7. Verfahren nach einem der Ansprüche 4 bis 6, **dadurch gekennzeichnet, daß** die Materialstücke (**LP**) an mindestens zwei Elektrodenanordnungen mit langgestreckt ausgebildeten Elektroden (**6,7**) vorbeigeführt werden, wobei die Elektroden (6,7) unterschiedlicher Elektrodenanordnungen unterschiedliche Winkel mit der Transportrichtung (**5**) bilden.

8. Verfahren nach einem der Ansprüche 4 bis 7, **dadurch gekennzeichnet, daß** die Elektroden (**6,7**) im wesentlichen parallel zur Transportebene oszillierend bewegt werden.

9. Verfahren nach einem der Ansprüche 4 bis 8, **dadurch gekennzeichnet, daß** die Elektrodenanordnungen von Isolierwänden (**13,14**) umgeben werden, zu den Oberflächen der Materialstücke (**LP**) ausgerichtete Öffnungen (**12**_{**k**}**,12**_{**a**}) an den Elektrodenanordnungen durch die Isolierwände (**13,14**) und die zwischen den Elektroden (**6,7**) angeordneten Isolierwände (**9**) gebildet werden und daß diese Öffnungen (**12**_{**k**}**,12**_{**a**}) in Transportrichtung (**5**) gesehen jeweils eine derartige Weite aufweisen, daß die den kathodisch gepolten Elektroden (**6**) zugeordneten Öffnungen (**12**_{**k**}) kleiner sind als die den anodisch gepolten Elektroden (**7**) zugeordneten Öffnungen (**12**_{**a**}), wenn das Verfahren zum Abscheiden von Metall auf den Materialstücken (**LP**) angewendet wird, oder daß die den kathodisch gepolten Elektroden (**6**) zugeordneten Öffnungen (**12**_{**k**}) größer sind als die den anodisch gepolten Elektroden (**7**) zugeordneten Öffnungen (**12**_{**a**}), wenn das Verfahren zum Ätzen von Metalloberflächen (**4**) auf den Materialstücken (**LP**) angewendet wird.

10. Verfahren nach einem der Ansprüche 4 bis 9, **dadurch gekennzeichnet, daß** die Materialstücke (**LP**) nach dem Vorbei-Führen an mindestens einer Elektrodenanordnung um 180° um eine auf der Transportebene senkrecht stehende Achse gedreht wird.

11. Verfahren nach einem der vorstehenden Ansprüche, **dadurch gekennzeichnet, daß** mehrere parallel zueinander angeordnete, benachbarte Elektrodenanordnungen mit langgestreckt ausgebildeten Elektroden (**6,7**) vorgesehen und zueinander benachbarte Elektroden (**6,7**) mit jeweils einer Strom/Spannungsquelle (**8**) verbunden werden.

12. Verfahren nach Anspruch 11, **dadurch gekennzeichnet, daß** die Stromdichte an den der ersten Elektrodenanordnung gegenüberliegenden Strukturen (**4**) etwa doppelt so groß eingestellt wird wie die Stromdichte an den der zweiten Elektrodenanordnungen gegenüberliegenden Strukturen (**4**).

13. Verfahren nach einem der vorstehenden Ansprüche, **dadurch gekennzeichnet, daß** Elektrolyträume (**10**), die die kathodisch gepolten Elektroden (**6**) umgeben, von ionensensitiven Membranen (**16**) abgeschirmt werden.

14. Verfahren nach einem der vorstehenden Ansprüche, **dadurch gekennzeichnet, daß** der elektrische Strom derart moduliert wird, daß eine unipolare oder bipolare Strompulsfolge durch die Elektroden (**6,7**) und die Oberflächen (**4**) fließt.

15. Anwendung des Verfahrens nach einem der Ansprüche 1 bis 14 zum elektrolytischen Behandeln von mit elektrisch gegeneinander isolierten, elektrisch leitfähigen Strukturen (**4**) versehenen, gegeneinander vereinzelten Platten- und Folienmateriaistücken (**LP**).

16. Anwendung des Verfahrens nach einem der Ansprüche 1 bis 14 zum Abscheiden von Metall auf den Materialstücken (LP), wobei die Materialstücke (LP) zuerst an mindestens einer kathodisch gepolten (6) und danach an mindestens einer anodisch gepolten Elektrode (**7**) vorbeigeführt werden.

17. Anwendung nach Anspruch 16 zum Abscheiden von Zinn auf Kupferoberflächen (**4**) auf den Materialstücken (**LP**).

18. Anwendung des Verfahrens nach einem der Ansprüche 1 bis 14 zum Ätzen von Metalloberflächen (**4**) auf den Materialstücken (**LP**), wobei die Materialstücke (**LP**) zuerst an mindestens einer anodisch gepolten (**7**) und danach an mindestens einer kathodisch gepolten Elektrode (**6**) vorbeigeführt werden.

19. Vorrichtung zum elektrolytischen Behandeln von elektrisch leitfähigen Oberflächen (**4**) auf gegeneinander vereinzelten Platten- und Folienmaterialstücken (**LP**), die folgende Merkmale aufweist:
a. mindestens eine Einrichtung zum In-Kontakt-Bringen der Materialstücke (**LP**) mit einer Behandlungsflüssigkeit (**3**);
b. geeignete Transportorgane für den Transport der vereinzelten Materialstücke (LP) in einer Transportrichtung (5) und in einer Transportebene durch eine Behandlungsanlage;
c. mindestens eine Elektrodenanordnung, jeweils bestehend aus mindestens einer kathodisch gepolten Elektrode (6) und mindestens einer anodisch gepolten Elektrode (7), wobei die mindestens eine kathodisch gepolte Elektrode (**6**) und die mindestens eine anodisch gepolte Elektrode (**7**) mit der Behandlungsflüssigkeit (**3**) in Kontakt bringbar sind,
d. wobei die kathodisch gepolten Elektroden (6) und die anodisch gepolten Elektroden (7) einer Elektrodenanordnung auf eine Seite der Transportebene ausgerichtet sind;
e. mindestens eine Isolierwand (**9**) zwischen entgegengesetzt gepolten Elektroden (**6**) und (**7**) in den Elektrodenanordnungen; und
f. mindestens eine Strom/Spannungsquelle (**8**), die mit den Elektrodenanordnungen elektrisch verbunden ist, zur Erzeugung eines Stromflusses durch die Elektroden (**6,7**) der Elektrodenanordnungen.

20. Vorrichtung nach Anspruch 19, **dadurch gekennzeichnet, daß** die mindestens eine lsolierwand (**9**) derart angeordnet ist, daß sie die Materialstücke (**LP**) während des Transportes durch die Behandlungsanlage berührt oder daß sie zumindest unmittelbar an die Materialstücke (**LP**) heranreicht.

21. Vorrichtung nach einem der Ansprüche 19 und 20, **dadurch gekennzeichnet, daß** die Elektroden (**6,7**) langgestreckt ausgebildet und im wesentlichen parallel zur Transportebene angeordnet sind.

22. Vorrichtung nach Anspruch 21, **dadurch gekennzeichnet, daß** sich die Elektroden (**6,7**) im wesentlichen senkrecht zur Transportrichtung (**5**) etwa über die gesamte Breite der von den Materialstücken (**LP**) eingenommenen Transportebene erstrecken.

23. Vorrichtung nach Anspruch 21, **dadurch gekennzeichnet, daß** die Elektroden (**6,7**) einen Winkel α ≠ 90° mit der Transportrichtung (**5**) bilden.

24. Vorrichtung nach einem der Ansprüche 19 bis 23, **dadurch gekennzeichnet, daß** mindestens zwei Elektrodenanordnungen mit langgestreckt ausgebildeten Elektroden (**6,7**) vorgesehen sind, wobei die Elektroden (**6,7**) unterschiedlicher Elektrodenanordnungen unterschiedliche Winkel mit der Transportrichtung (**5**) bilden.

25. Vorrichtung nach einem der Ansprüche 21 bis 24, **dadurch gekennzeichnet, daß** die langgestreckten Elektroden (**6,7**) derart ausgebildet sind, daß sie im wesentlichen parallel zur Transportebene oszillierend bewegbar sind.

26. Vorrichtung nach einem der Ansprüche 19 bis 25, **dadurch gekennzeichnet, daß** die Elektrodenanordnungen von Isolierwänden (**13,14**) umgeben sind, zur Transportebene hin ausgerichtete Öffnungen (**12**_{**k**}**,12**_{**a**}) an den Elektrodenanordnungen durch die Isolierwände (**13,14**) und zwischen den Elektroden (**6,7**) angeordnete Isolierwände (**9**) gebildet sind und daß diese Öffnungen (**12**_{**k**}**,12**_{**a**}) in Transportrichtung gesehen jeweils eine derartige Weite aufweisen, daß die den kathodisch gepolten Elektroden (**6**) zugeordneten Öffnungen (**12**_{**k**}) kleiner sind als die den anodisch gepolten Elektroden (**7**) zugeordneten Öffnungen (**12**_{**a**}), wenn die Vorrichtung zum Abscheiden von Metall auf den Materialstücken (**LP**) verwendet wird, oder daß die den kathodisch gepolten Elektroden (**6**) zugeordneten Öffnungen (**12**_{**k**}) größer sind als die den anodisch gepolten Elektroden (**7**) zugeordneten Öffnungen (**12**_{**a**}), wenn die Vorrichtung zum Ätzen von Metalloberflächen (**4**) verwendet wird.

27. Vorrichtung nach einem der Ansprüche 19 bis 26, **dadurch gekennzeichnet, daß** Elektrolyträume (**10**), die die kathodisch gepolten Elektroden (**6**) umgeben, durch ionensensitive Membranen (**16**) abgeschirmt sind.

28. Vorrichtung nach einem der Ansprüche 19 bis 27, **dadurch gekennzeichnet, daß** mehrere parallel zueinander angeordnete, benachbarte Etektrodenanordnungen mit langgestreckt ausgebildeten Elektroden (**6,7**) vorgesehen und zueinander benachbarte Elektroden (**6,7**) mit jeweils einer separaten Strom/Spannungsquelle (**8**) verbunden sind.

## Claims

1. Method for the electrolytic treatment of electrically conductive surfaces (4) of plate and film material pieces (LP) which are isolated from one another, in which method the material pieces (LP)
a. are conveyed through a processing plant and thereby brought into contact with treatment fluid (3);
b. as they are conveyed, are led past at least one electrode arrangement, comprising in each case at least one cathodically polarised electrode (6) and at least one anodically polarised electrode (7), the at least one cathodically polarised electrode (6) and the at least one anodically polarised electrode (7) being brought into contact with the treatment fluid (3) and being connected to a current/voltage source (8), such that a current flows through the electrodes (6,7) and the electrically conductive surfaces (4),
c. the electrodes (6,7) of an electrode arrangement being disposed in such a way that they are oriented towards one side of the material pieces (LP), and that at least one insulating wall (9) is disposed between the electrodes (6,7).

2. Method according to claim 1, **characterised in that** the at least one insulating wall (9) is disposed in such a way that it touches the material pieces (LP) as they are conveyed through the processing plant or that it extends at least directly to the material pieces (LP).

3. Method according to one of the preceding claims, **characterised in that** the material pieces (LP) are led in succession past at least two electrode arrangements.

4. Method according to one of the preceding claims, **characterised in that** the material pieces (LP) are conveyed in one direction of conveyance (5) and in one plane of conveyance, and **in that** the electrodes (6, 7) are configured elongate and disposed substantially parallel to the plane of conveyance.

5. Method according to claim 4, **characterised in that** the electrodes (6,7) extend substantially perpendicularly with respect to the direction of conveyance (5) over roughly the entire width of the material pieces (LP).

6. Method according to claim 4, **characterised in that** the electrodes (6,7) form an angle α ≠ 90° with the direction of conveyance (5).

7. Method according to one of claims 4 to 6, **characterised in that** the material pieces (LP) are led past at least two electrode arrangements having elongate electrodes (6, 7), the electrodes (6, 7) of different electrode arrangements forming different angles with the direction of conveyance (5).

8. Method according to one of claims 4 to 7, **characterised in that** the electrodes (6,7) are moved oscillating substantially parallel to the plane of conveyance.

9. Method according to one of claims 4 to 8, **characterised in that** the electrode arrangements are surrounded by insulating walls (13, 14), openings (12ₖ, 12ₐ) oriented towards the surfaces of the material pieces (LP) are formed at the electrode arrangements by insulating walls (13, 14) and insulating walls (9) disposed between the electrodes (6, 7), and **in that** these openings (12ₖ, 12ₐ), when viewed with respect to the direction of conveyance, are each of such a width that the openings (12ₖ) associated with the cathodically polarised electrodes (6) are smaller than the openings (12ₐ) associated with the anodically polarised electrodes (7), when the method is used to deposit metal on the material pieces (LP), or that the openings (12ₖ) associated with the cathodically polarised electrodes (6) are larger than the openings (12ₐ) associated with the anodically polarised electrodes (7) when the method is used for etching metal surfaces (4) on the material pieces (LP).

10. Method according to one of claims 4 to 9, **characterised in that** the material pieces (LP) are rotated by 180° about an axis standing perpendicularly on the plane of conveyance after they have been led past at least one electrode arrangement.

11. Method according to one of the preceding claims, **characterised in that** a plurality of adjacent electrode arrangements having elongate electrodes (6, 7) are provided disposed parallel to one another, and electrodes (6,7) adjacent one another are connected to respectively one current/voltage source (8).

12. Method according to claim 11, **characterised in that** the current density at the structures (4) facing the first electrode arrangement is set roughly twice as high as the current density at the structures (4) facing the second electrode arrangements.

13. Method according to one of the preceding claims, **characterised in that** electrolyte chambers (10), which surround the cathodically polarised electrodes (6), are shielded by ion-selective membranes (16).

14. Method according to one of the preceding claims, **characterised in that** the electric current is modulated in such a way that a unipolar or bipolar current pulse sequence flows through the electrodes (6, 7) and the surfaces (4).

15. Application of the method according to one of claims 1 to 14 for the electrolytic treatment of plate and film material pieces (LP) which are isolated from one another and provided with electrically conductive structures which are electrically insulated from one another.

16. Application of the method according to one of claims 1 to 14 for depositing metal on the material pieces (LP), the material pieces (LP) being led first past at least one cathodically polarised electrode (6) and then past at least one anodically polarised electrode (7).

17. Application according to claim 16 for depositing tin on copper surfaces (4) on the material pieces (LP).

18. Application of the method according to one of claims 1 to 14 for etching metal surfaces (4) on the material pieces (LP), the material pieces (LP) being led first past at least one anodically polarised electrode (7) and then past at least one cathodically polarised electrode (6).

19. Apparatus for the electrolytic treatment of electrically conductive surfaces (4) on plate and film material pieces (LP) which are isolated from one another, said apparatus having the following features:
a. at least one device for bringing the material pieces (LP) into contact with a treatment fluid (3);
b. suitable conveying members for conveying the isolated material pieces (LP) in one direction of conveyance (5) and in one plane of conveyance through a processing plant;
c. at least one electrode arrangement, in each case comprising at least one cathodically polarised electrode (6) and at least one anodically polarised electrode (7), the at least one cathodically polarised electrode (6) and the at least one anodically polarised electrode (7) being capable of being brought into contact with the treatment fluid (3),
d. the cathodically polarised electrodes (6) and the anodically polarised electrodes (7) of an electrode arrangement being oriented towards one side of the plane of conveyance;
e. at least one insulating wall (9) between oppositely polarised electrodes (6) and (7) in the electrode arrangements; and
f. at least one current/voltage source (8), which is electrically connected to the electrode arrangements, to generate a flow of current through the electrodes (6,7) of the electrode arrangements.

20. Apparatus according to claim 19, **characterised in that** the at least one insulating wall (9) is disposed in such a way that it touches the material pieces (LP) as they are conveyed through the processing plant, or that it extends at least directly to the material pieces (LP).

21. Apparatus according to one of claims 19 and 20, **characterised in that** the electrodes (6,7) are configured elongate and are disposed substantially parallel to the plane of conveyance.

22. Apparatus according to claim 21, **characterised in that** the electrodes (6,7) extend substantially perpendicularly with respect to the direction of conveyance (5) roughly over the entire width of the plane of conveyance assumed by the material pieces (LP).

23. Apparatus according to claim 21, **characterised in that** the electrodes (6,7) form an angle α ≠ 90° with the direction of conveyance (5).

24. Apparatus according to one of claims 19 to 23, **characterised in that** at least two electrode arrangements having elongate electrodes (6,7) are provided, the electrodes (6,7) of different electrode arrangements forming different angles with the direction of conveyance (5).

25. Apparatus according to one of claims 21 to 24, **characterised in that** the elongate electrodes (6,7) are configured in such a way that they can be moved oscillating substantially parallel to the plane of conveyance.

26. Apparatus according to one of claims 19 to 25, **characterised in that** the electrode arrangements are surrounded by insulating walls (13, 14), openings (12ₖ, 12ₐ) oriented towards the plane of conveyance are formed at the electrode arrangements by insulating walls (13, 14) and insulating walls (9) disposed between the electrodes (6, 7), and **in that** these openings (12ₖ, 12ₐ), when viewed with respect to the direction of conveyance, are each of such a width that the openings (12ₖ) associated with the cathodically polarised electrodes (6) are smaller than the openings (12ₐ) associated with the anodically polarised electrodes (7), when the apparatus is used to deposit metal on the material pieces (LP), or that the openings (12ₖ) associated with the cathodically polarised electrodes (6) are larger than the openings (12ₐ) associated with the anodically polarised electrodes (7) when the apparatus is used for etching metal surfaces (4).

27. Apparatus according to one of claims 19 to 26, **characterised in that** electrolyte chambers (10), which surround the cathodically polarised electrodes (6), are shielded by ion-selective membranes (16).

28. Apparatus according to one of claims 19 to 27, **characterised in that** a plurality of adjacent electrode arrangements having elongate electrodes (6, 7) are provided disposed parallel to one another, and electrodes (6,7) adjacent one another are connected to respectively one current/voltage source (8).

## Revendications

1. Procédé de traitement électrolytique de surfaces électroconductrices (4) de pièces en cartes ou en films (LP) séparées les unes des autres, dans lequel les pièces (LP)
a. sont transportées par une installation de traitement et mises en contact avec un liquide de traitement (3) ;
b. passent pendant le transport devant au moins un dispositif d'électrodes, respectivement composé d'au moins une électrode polarisée en cathode (6) et au moins une électrode polarisée en anode (7), moyennant quoi au moins une électrode polarisée en cathode (6) et au moins une électrode polarisée en anode (7) sont mises en contact avec le liquide de traitement (3) et reliées à une source de courant/tension (8), de sorte qu'un courant circule dans les électrodes (6, 7) et les surfaces électroconductrices (4),
c. moyennant quoi les électrodes (6, 7) d'un dispositif d'électrodes sont disposées de telle sorte qu'elles sont alignées sur une face des pièces (LP) et qu'au moins une paroi isolante (9) est disposée entre les électrodes (6, 7).

2. Procédé selon la revendication 1, **caractérisé en ce qu'**au moins une paroi isolante (9) est disposée de telle sorte qu'elle touche les pièces (LP) lors du transport par l'installation de traitement ou qu'elle atteigne au moins directement les pièces (LP).

3. Procédé selon l'une quelconque des revendications précédentes, **caractérisé en ce que** les pièces (LP) passent successivement devant au moins deux dispositifs d'électrodes.

4. Procédé selon l'une quelconque des revendications précédentes, **caractérisé en ce que** les pièces (LP) sont transportées dans un sens de transport (5) et dans un plan de transport, et **en ce que** les électrodes (6, 7) sont configurées de façon étendue longitudinalement et sont disposées essentiellement parallèlement au plan de transport.

5. Procédé selon la revendication 4, **caractérisé en ce que** les électrodes (6, 7) s'étendent essentiellement perpendiculairement au sens de transport (5) approximativement sur toute la largeur des pièces (LP).

6. Procédé selon la revendication **4**, **caractérisé en ce que** les électrodes (6, 7) forment un angle α ≠90° avec le sens de transport (5).

7. Procédé selon l'une quelconque des revendications 4 à 6, **caractérisé en ce que** les pièces (LP) passent devant au moins deux dispositifs d'électrodes avec des électrodes (6, 7) configurées de façon étendue longitudinalement, moyennant quoi les électrodes (6, 7) des différents dispositifs d'électrodes forment différents angles avec le sens de transport (5).

8. Procédé selon l'une quelconque des revendications 4 à 7, **caractérisé en ce que** les électrodes (6, 7) sont déplacées de façon oscillante essentiellement parallèlement au plan de transport.

9. Procédé selon l'une quelconque des revendications 4 à 8, **caractérisé en ce que** les dispositifs d'électrodes sont entourés par des parois isolantes (13, 14), des ouvertures (12ₖ, 12ₐ) orientées vers les surfaces des pièces (LP) sont formées sur les dispositifs d'électrodes par les parois isolantes (13, 14) et les parois isolantes (9) disposées entre les électrodes (6, 7), et **en ce que** ces ouvertures (12ₖ, 12ₐ) du point de vue du sens de transport (5) présentent respectivement une largeur telle que les ouvertures (12ₖ) attribuées aux électrodes (6) polarisées en cathode sont inférieures aux ouvertures (12ₐ) attribuées aux électrodes (7) polarisées en anode, lorsque le procédé de séparation du métal est appliqué sur les pièces (LP), ou **en ce que** les ouvertures (12ₖ) attribuées aux électrodes (6) polarisées en cathode sont supérieures aux ouvertures (12ₐ) attribuées aux électrodes (7) polarisées en anode, lorsque le procédé de mordançage des surfaces métalliques (4) est appliqué sur les pièces (LP).

10. Procédé selon l'une quelconque des revendications 4 à 9, **caractérisé en ce que** la pièce (LP) après le passage devant au moins un dispositif d'électrodes est tournée à 180° autour d'un axe situé perpendiculairement au plan de transport.

11. Procédé selon l'une quelconque des revendications précédentes, **caractérisé en ce que** plusieurs dispositifs d'électrodes adjacents disposés parallèlement les uns aux autres sont équipés d'électrodes (6, 7) configurées de façon étendue longitudinalement et **en ce que** les électrodes (6, 7) adjacentes sont reliées respectivement à une source de courant/tension.

12. Procédé selon la revendication 11, **caractérisé en ce que** la densité de courant sur les structures (4) opposées au premier dispositif d'électrodes est environ deux fois supérieure à la densité de courant sur les structures (4) opposées au second dispositif d'électrodes.

13. Procédé selon l'une quelconque des revendications précédentes, **caractérisé en ce que** les espaces électrolytiques (10) qui entourent les électrodes (6) polarisées en cathode sont protégés par des membranes (16) sensibles aux ions.

14. Procédé selon l'une quelconque des revendications précédentes, **caractérisé en que** le courant électrique est modulé de telle sorte qu'un train d'impulsions électriques unipolaire ou bipolaire circule dans les électrodes (6, 7) ou les surfaces (4).

15. Utilisation du procédé selon l'une quelconque des revendications 1 à 14 pour le traitement électrolytique de pièces (LP) en cartes ou en films séparées les unes des autres et munies de structures (4) électroconductrices isolées électriquement les unes des autres.

16. Utilisation du procédé selon l'une quelconque des revendications 1 à 14 pour la séparation du métal sur les pièces (LP), moyennant quoi les pièces (LP) sont tout d'abord conduites vers au moins une électrode (6) polarisée en cathode et ensuite vers au moins une électrode (7) polarisée en anode.

17. Utilisation du procédé selon la revendication 16 pour la séparation de l'étain sur les surfaces en cuivre (4) des pièces (LP).

18. Utilisation du procédé selon l'une quelconque des revendications 1 à 14 pour le mordançage des surfaces métalliques (4) des pièces (LP), moyennant quoi les pièces (LP) sont tout d'abord conduites vers au moins une électrode (7) polarisée en anode et ensuite vers au moins une électrode (6) polarisée en cathode.

19. Dispositif de traitement électrolytique de surfaces électroconductrices (4) sur des pièces (LP) en cartes ou en films séparées présentant les caractéristiques suivantes :
a. au moins une installation de mise en contact de la pièce (LP) avec le liquide de traitement (3) ;
b. des organes de transport appropriés pour le transport des pièces (LP) séparées dans un sens de transport (5) et dans un plan de transport par une installation de traitement ;
c. au moins un dispositif d'électrodes, respectivement composé d'au moins une électrode (6) polarisée en cathode et au moins une électrode (7) polarisée en anode, moyennant quoi au moins une électrode polarisée en cathode (6) et au moins une électrode (7) polarisée en anode peuvent être mises en contact avec le liquide de traitement (3).
d. les électrodes (6) polarisées en cathode et les électrodes (7) polarisées en anode d'un dispositif d'électrodes sont alignées sur une face du plan de transport ;
e. au moins une paroi isolante (9) est située entre les électrodes (6) et (7) polarisées en sens inverse dans les dispositifs d'électrodes, et
f. au moins une source de courant/tension (8) qui est reliée électriquement aux dispositifs d'électrodes, en vue de la production d'un flux de courant dans les électrodes (6, 7) des dispositifs d'électrodes.

20. Dispositif selon la revendication 19, **caractérisé en ce qu'**au moins une paroi isolante (9) est disposée de telle sorte qu'elle touche les pièces (LP) pendant le transport par l'installation de traitement ou **en ce qu'**elle atteint au moins directement les pièces (LP).

21. Dispositif selon l'une quelconque des revendications 19 et 20, **caractérisé en ce que** les électrodes (6, 7) sont configurées de façon étendue longitudinalement et sont disposées essentiellement parallèlement au plan de transport.

22. Dispositif selon la revendication 21, **caractérisé en ce que** les électrodes (6, 7) s'étendent essentiellement perpendiculairement au sens de transport (5) approximativement sur toute la largeur du plan de transport suivi par les pièces (LP).

23. Dispositif selon la revendication 21, **caractérisé en ce que** les électrodes (6, 7) forment un angle de α ≠90° avec le sens de transport (5).

24. Dispositif selon l'une quelconque des revendications 19 à 23, **caractérisé en ce qu'**au moins deux dispositifs d'électrodes sont équipés d'électrodes (6, 7) configurées de façon étendue longitudinalement, moyennant quoi les électrodes (6, 7) des différents dispositifs d'électrodes forment différents angles avec le sens de transport (5).

25. Dispositif selon l'une quelconque des revendications 21 à 24, **caractérisé en ce que** les électrodes (6, 7) sont configurées de façon étendue longitudinalement de telle sorte qu'elle peuvent être déplacées de façon oscillante essentiellement parallèlement au plan de transport.

26. Dispositif selon l'une quelconque des revendications 19 à 25, **caractérisé en ce que** les dispositifs d'électrodes sont entourés de parois isolantes (13, 14), des ouvertures (12ₖ, 12ₐ) orientées vers le plan de transport sont formées sur les dispositifs d'électrodes par les parois isolantes (13, 14) et les parois isolantes (9) disposées entre les électrodes (6, 7), et **en ce que** ces ouvertures (12ₖ, 12ₐ) du point de vue du sens de transport présentent respectivement une largeur telle que les ouvertures (12ₖ) attribuées aux électrodes (6) polarisées en cathode sont inférieures aux ouvertures (12ₐ) attribuées aux électrodes (7) polarisées en anode, lorsque le procédé de séparation du métal est utilisé sur les pièces (LP), ou **en ce que** les ouvertures (12ₖ) attribuées aux électrodes (6) polarisées en cathode sont supérieures aux ouvertures (12ₐ) attribuées aux électrodes (7) polarisées en anode, lors de l'application du procédé de mordançage des surfaces métalliques (4).

27. Dispositif selon l'une quelconque des revendications 19 à 26, **caractérisé en ce que** les espaces électrolytiques (10) qui entourent les électrodes (6) polarisées en cathode sont protégés par des membranes (16) sensibles aux ions.

28. Dispositif selon l'une quelconque des revendications 19 à 27, **caractérisé en ce que** plusieurs dispositifs d'électrodes adjacents disposés parallèlement les uns aux autres sont équipés d'électrodes (6, 7) configurées de façon étendue longitudinalement et **en ce que** les électrodes (6, 7) adjacentes sont reliées respectivement à une source de courant/tension (8) séparée.
